(19) Europäisches Patentamt
European Patent Office
Office européen des brevets

(11) EP 1 749 240 B1

(12) **EUROPEAN PATENT SPECIFICATION**

(45) Date of publication and mention of the grant of the patent:
**11.04.2012 Bulletin 2012/15**

(21) Application number: **05743030.8**

(22) Date of filing: **27.04.2005**

(51) Int Cl.:
***G03F 7/09*** *(2006.01)*

(86) International application number:
**PCT/EP2005/051885**

(87) International publication number:
**WO 2005/109103 (17.11.2005 Gazette 2005/46)**

(54) **PHOTOPOLYMER PRINTING PLATE PRECURSOR.**

FOTOPOLYMER-DRUCKPLATTEN-VORLÄUFER

PRECURSEUR DE PLAQUE D'IMPRESSION PHOTOPHOLYMERE

(84) Designated Contracting States:
**AT BE BG CH CY CZ DE DK EE ES FI FR GB GR HU IE IS IT LI LT LU MC NL PL PT RO SE SI SK TR**

(30) Priority: **06.05.2004 EP 04101955**
**07.06.2004 US 577674 P**

(43) Date of publication of application:
**07.02.2007 Bulletin 2007/06**

(73) Proprietor: **Agfa Graphics N.V.**
**2640 Mortsel (BE)**

(72) Inventors:
- **GRIES, Willi-Kurt**
  **55252 Mainz-Kastel (DE)**
- **VAN DAMME, Marc,**
  **c/o AGFA-GEVAERT**
  **B-2640 Mortsel (BE)**

(74) Representative: **Goedeweeck, Rudi et al**
**Agfa Graphics N.V.**
**IP Department 3622**
**Septestraat 27**
**2640 Mortsel (BE)**

(56) References cited:
**EP-A- 0 738 929** **EP-A- 1 288 722**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 749 240 B1

## Description

### FIELD OF THE INVENTION

The present invention relates to a photopolymer printing plate precursor comprising in this order a photosensitive coating and a protective coating on a support, wherein said photosensitive coating comprises a composition that is photopolymerizable upon absorption of light, said composition comprising a binder, a polymerizable compound, a radical stabilizer, a sensitizer and a photoinitiator.

The invention also relates to a method of making a lithographic printing plate therewith.

### BACKGROUND OF THE INVENTION

In lithographic printing, a so-called printing master such as a printing plate is mounted on a cylinder of the printing press. The master carries a lithographic image on its surface and a printed copy is obtained by applying ink to said image and then transferring the ink from the master onto a receiver material, which is typically paper. In conventional, so-called "wet" lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called "driographic" printing, the lithographic image consists of ink-accepting and ink-abhesive (ink-repelling) areas and during driographic printing, only ink is supplied to the master.

Printing masters are generally obtained by the so-called computer-to-film (CtF) method, wherein various pre-press steps such as typeface selection, scanning, color separation, screening, trapping, layout and imposition are accomplished digitally and each color selection is transferred to graphic arts film using an imagesetter. After processing, the film can be used as a mask for the exposure of an imaging material called plate precursor and after plate processing, a printing plate is obtained which can be used as a master. Since about 1995, the so-called 'computer-to-plate' (CtP) method has gained a lot of interest. This method, also called 'direct-to-plate', bypasses the creation of film because the digital document is transferred directly to a printing plate precursor by means of a so-called plate-setter. A printing plate precursor for CtP is often called a digital plate.

Digital plates can roughly be divided in three categories : (i) silver plates, which work according to the silver salt diffusion transfer mechanism; (ii) photopolymer plates which contain a photopolymerizable composition that hardens upon exposure to light and (iii) thermal plates of which the imaging mechanism is triggered by heat or by light-to-heat conversion. Thermal plates are mainly sensitized for infrared lasers emitting at 830 nm or 1064 nm. Typical photopolymer plates are sensitized for visible light, mainly for exposure by an Ar laser (488 nm) or a FD-YAG laser (532 nm). The wide-scale availability of low cost blue or violet laser diodes, originally developed for data storage by means of DVD, has enabled the production of plate-setters operating at shorter wavelength. More specifically, semiconductor lasers emitting from 350 to 450 nm have been realized using an InGaN material.

Radicals are involved in the hardening reaction of the photopolymerizable composition of photopolymer plates and said hardening reaction is known to be adversely affected by oxygen. To reduce this problem it is known to provide the photosensitive coating with a protective coating, also called oxygen barrier layer, protective overcoat or overcoat layer.

According to DE 26 29 883 A1 the oxygen barrier layer of a presensitized lithographic printing plate should contain a poly(vinyl alcohol), wherein at least 2 % of the hydroxy groups of said poly(vinyl alcohol) are esterified by a dicarboxylic acid, to provide an oxygen barrier layer, that can be dissolved in the same solvent as used for the developer and that does not adversely effect the image forming process. The printing plate precursors known from DE 26 29 883 only have a low sensitivity, what is disclosed on p. 17, reading that low exposure (corresponding to high sensitivity) means 3 s when using 4 high pressure mercury vapour lamps of 150 Watts each.

EP 1 148 387 A1 discloses photographic printing plates comprising a photosensitive layer and a protective layer, that have a maximum peak of spectral sensitivity with a wavelength range of from 390 to 430 nm, and wherein the minimum exposure for the photosensitive lithographic printing plate for image formation at a wavelength of 410 nm is at most 100 $\mu J/cm^2$. Said protective layer is provided on the photosensitive layer as oxygen-shielding layer and preferred examples of protective layers according to EP 1 148 387 A1 contain water-soluble polymers such as poly(vinyl alcohol), poly(vinyl pyrrolidone), poly(ethylene oxide) and cellulose; a mixture of poly(vinyl alcohol) and poly(vinyl pyrrolidone) being particularly preferred.

According to EP 1 280 006 A2 a protective layer is provided on the layer of photopolymerizable composition, wherein said protective layer inhibits the penetration of a low molecular compound such as oxygen and can contain water-soluble polymers that have relatively high crystallinity. Preferably poly(vinyl alcohol) with a saponification degree of 71 % to 100 % is used as a basic component, that may be partially replaced by an ester, ether or acetal, and the photopolymerizable composition comprises a photopolymerization initiation system consisting of a specific sensitizing dye and a titanocene compound.

To improve the behaviour of photopolymerization compositions prior to exposure, that is to reduce unwanted polymerization during preparation and storage of photopolymerizable compositions it is known from e.g. EP 0 924 570 A1, EP 1 035 435 A2, EP 1 070 990 A1 and EP 1 081 552 A1 to add thermopolymerization inhibitors to the photosensitive compositions.

EP 0 738 929 discloses a photopolymerizable sensitive material which comprises a support, a photopolymerizable sensitive layer comprising an addition polymerizable compound, a photopolymerizable initiator and a binder, formed on a support, and a protective layer formed thereon, that comprises a mixture of (a) polyvinylalcohol and/or a polyvinylalcohol derivative (PVA) and (b) a polyvinyl pyrrolidone (PVP), whereby the proportion of component (a) in the total amount of components (a) and (b) is from 25 to 75 weigth %.

EP 1 288 722 discloses a printing plate precursor, wherein the photopolymerizable layer comprises a titanocene type initiator.

After imaging (exposing) the photopolymer printing plate precursor, the plate is heated for a short time to high temperatures before the overcoat is washed off and the photolayer is developed. This heating step is hereinafter called pre-heat step. During the pre-heat step typical temperatures, when measured at the back of the plate, from about 90°C to 150°C are used for a short time, typically between 10 seconds and 1 minute. As the conditions of the pre-heat step vary with different types of processors and even for the same processor, a printing plate should exhibit consistent results irrespective to the pre-heat conditions, in particular to the temperature. The range of pre-heat conditions, wherein a printing plate exhibits consistent results is called the pre-heat latitude of said plate.

In particular when using high pre-heat temperatures, so called 'asteroid' defects often occur in non-image areas of known printing plates. Such asteroids are of irregular shape having a mean diameter of about 1 to 50 μm. As such asteroids adsorb ink and therefore are printing, although being in an unexposed area, they deteriorate the quality of the resulting print and are prohibitive for high quality results. The maximum pre-heat temperature that can be used for a given printing plate precursor without the occurence of asteroid defects is called $T_{max}$('asteroid'-free).

The photopolymer printing plate precursors according to the prior art are unsatisfactory, as such plates exhibit an unsatisfactory $T_{max}$ ('asteroid'-free), in particular when providing sufficient speed (sensitivity) to enable a short exposure time with the commercially available low cost and low power blue or violet laser diodes.

SUMMARY OF THE INVENTION

It is an object of the present invention to provide a highspeed photopolymer printing plate precursor, that has a high $T_{max}$('asteroid'-free) and therefore is suitable for all known types of processors and processes used to make a printing plate. This object is realized as defined in claim 1. The printing plate precursor of the present invention is a flexographic or lithographic printing plate precursor, the latter being highly preferred. Also a method of making a lithographic printing plate, wherein said printing plate precursor is exposed with a laser having an emission wavelength in the range from 300 to 450 nm, is an aspect of the present invention. Preferred photopolymer printing plate precursors according to the present invention can be exposed with an energy density, measured on the surface of the plate of 100 $\mu J/cm^2$ or less. Preferred embodiments of the printing plate precursor, of the method of making a lithographic printing plate and of the use according to the present invention are defined in the dependent claims.

DETAILED DESCRIPTION OF THE INVENTION

The present invention relates to a photopolymer printing plate precursor comprising in this order a photosensitive coating and a protective coating on a support, wherein said photosensitive coating comprises a composition that is photopolymerizable upon absorption of light, said composition comprising a binder, a polymerizable compound, a radical stabilizer, a sensitizer and a photoinitiator, characterized in that the photoinitiator is a hexaaryl-bisimidazole compound and the protective layer has a dry coating weight from 0.5 $g/m^2$ to less than 2.0 $g/m^2$, preferrably from 0.50 $g/m^2$ to 1.90 $g/m^2$, and contains at least one type of poly(vinyl alcohol), having a saponification degree less than 93 mol%, and a poly (vinyl pyrrolidone) in an amount from 0 to 10 parts by weight of the poly(vinyl alcohol).

By adjusting the dry coating weight of the protective layer of a photopolymer printing plate precursor to an amount smaller than 2.0 $g/m^2$, a substantially higher $T_{max}$('asteroid'-free) can be achieved, if the photopolymerizable composition covered by said protective layer comprises a radical stabilizer.

According to the present invention, said photoinitiator is a hexaaryl-bisimidazole compound. Using said photoinitiator results in a higher $T_{max}$('asteroid'-free) and in a higher sensitivity compared to known printing plate precursors.

According to the present invention, the saponification degree of the polyvinylalcohol is less than 93 mol-% and a polyvinylpyrrolidone is used in an amount from 0 to 10 parts by weight of the polyvinylalcohol. In a preferred embodiment, a mixture of at least two types of polyvinylalcohol are used having an overall mean saponification degree of all the polyvinylalcohols which are used in the protective coating of less than 93 mol-% and a polyvinylpyrrolidone is used in an amount from 0 to 10 parts by weight of the polyvinylalcohols. Thereby is achieved a printing plate precursor having

a higher $T_{max}$('asteroid'-free), the dot gain of which depends less on the pre-heat temperature.

The radical stabilizer used in the present invention can be selected from known radical stabilizers. Compounds useful as radical stabilizers of the present invention are also known as antioxidants or radical scavengers that are used as additives for e.g. polymers. Preferably the radical stabilizer used in the present invention is a compound selected from the group consisting of phenoles, organic phosphites, organic phosphonites, amines, hydroxylamines, lactones, hydrochinones, divalent sulfur compounds like thioethers and thioesters, metal complexants, wherein phenoles comprise mono-, di- and trihydroxyphenyl compounds, and in particular the radical stabilizer used in the present invention is a compound selected from the group consisting of hindered phenoles, o-alkylated hydrochinones, organic phosphites, organic phosphonites, aromatic amines, hindered amines, dialkyl hydroxylamines, benzofuranones and dialkyl thiodipropionates. The members of said groups are also called classes in the following.

Hindered phenoles that are particularly preferred for the present invention are substituted by at least one tertiary butyl group neighbouring to the phenolic hydroxy group. Further advantages can be achieved with phenolic compounds that contain long chain alkyl or alkylene groups, in particular such groups having from 6 to 25 C-atoms, from 9 to 22 C-atoms being further preferred. The phenolic compounds can comprise one, two, three or more phenol rings (mono-, di-, tri- or poly-phenolic compounds), one to six phenol rings beeing preferred. Tocopherols (see e.g. stabilizer (ST-20) in the following) are also useful radical stabilizers according to the present invention.

The organic phospites and phosphonites of the present invention preferably are esters of hindered phenols as defined above and/or esters of long chain alkoxy groups, wherein long chain has the same meaning as defined above.

Aromatic amines used as stabilizers according to the present invention preferably are N,N'-disubstituted p-phenylenediamines, substituted diphenylamines or substituted dihydrochinolines, wherein optionally substituted phenyl groups and/or alkyl groups are preferred as substituents.

Hindered amines, known as light stabilizers, are also useful radical stabilizers of the present invention. Preferred hindered amines are derivatives of 2,2,6,6-tetramethylpiperidine (see e.g. (ST-28) in the following).

A radical stabilizer according to the present invention can belong to only one of the classes listed above, but can also belong to two, three or a plurality of thoses classes. For example the stabilizer of formula (ST-13) (see below) belongs to the classes hindered phenoles and thioethers.

Some radical stabilizers, when incorporated in the photopolymerizable composition of the present invention, improve the $T_{max}$('asteroid'-free) even if the protective layer has a dry coating weight of 2.0 g/$m^2$ or more, in particular up to 5.0 g/$m^2$. Such stabilizers are called hereinafter particular efficient stabilizers. Nevertheless even when using said particular efficient stabilizers, the $T_{max}$('asteroid'-free) is substantially improved, if the protective layer has a dry coating weight of 0.5 to less then 2.0 g/$m^2$.

In a particularly preferred embodiment of the present invention, the radical stabilizer is selected from the group of particular efficient stabilizers, this group consisting of phenolic compounds with more than two phenolic groups, organic phosphites, organic phosphonites and hindered amines.

In a further preferred embodiment of the present invention the group of particular efficient stabilizers consists of hindered tri- and tetra-phenoles, hindered phenol esters of organic phosphites and hindered phenol esters of organic phosphonites.

The photosensitive coating according to the present invention can comprise one, two, three or more different radical stabilizers. In the case where it contains more than one radical stabilizer, said compounds can belong to the same or different classes.

Preferred examples of radical stabilizers according to the present invention are given in the following.

I) Hindered phenoles

(ST-1) 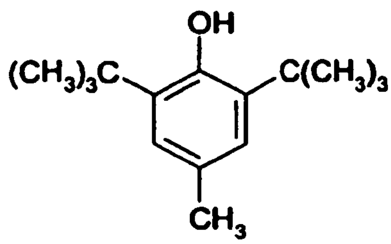

(ST-2)

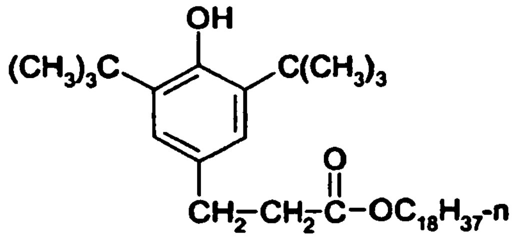

(ST-3)

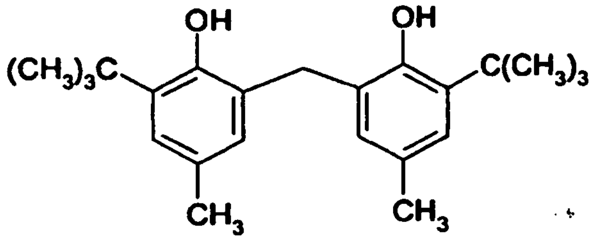

(ST-4)

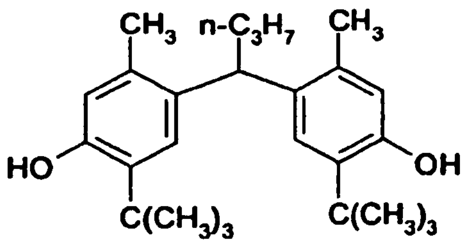

(ST-5)

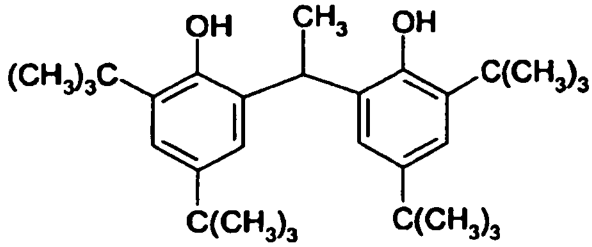

(ST-6)

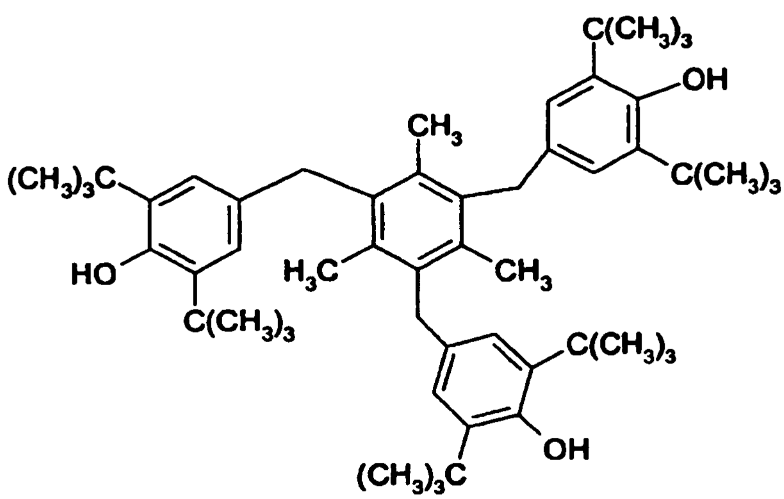

(ST-7)

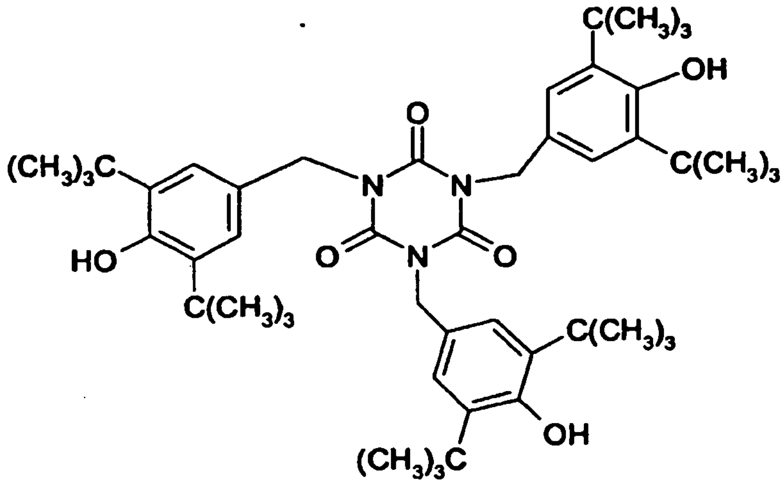

(ST-8)

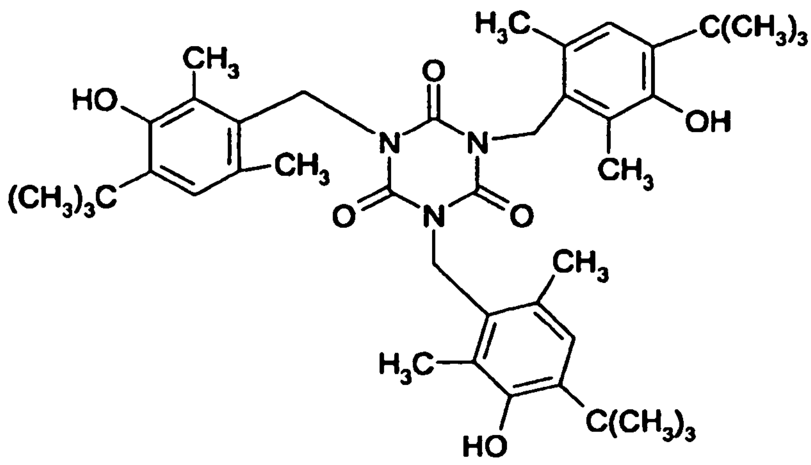

(ST-9)

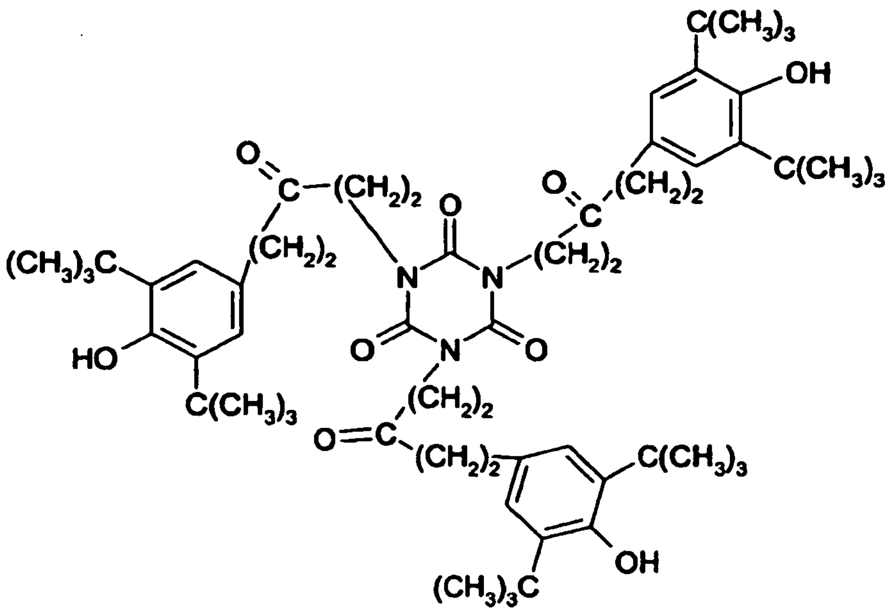

(ST-10)

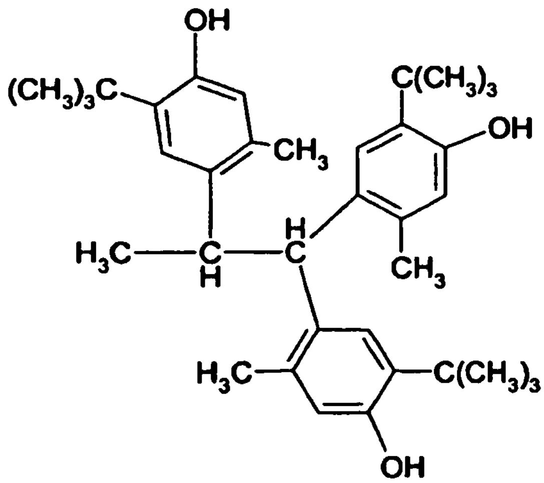

(ST-11)

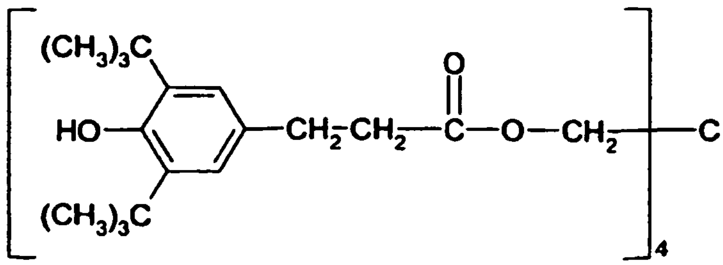

(ST-12)

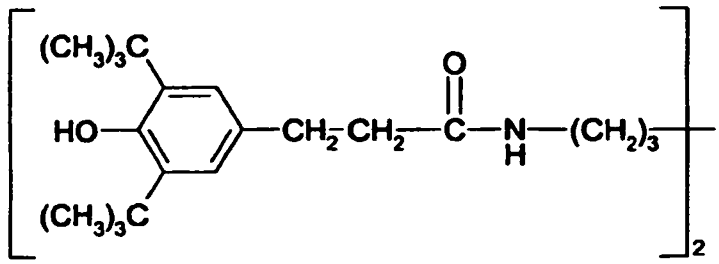

(ST-13)

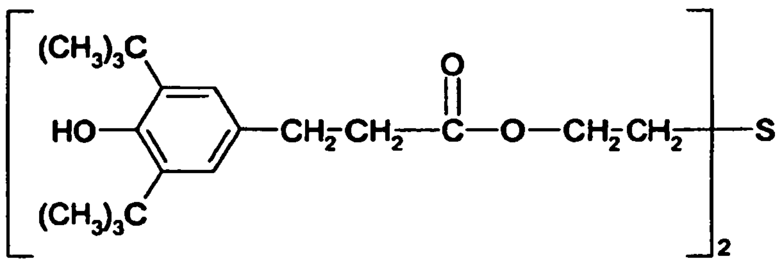

(ST-14)

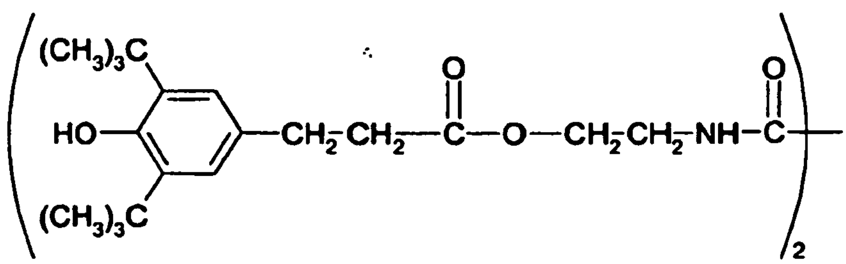

(ST-15)

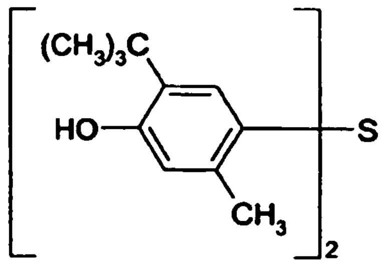

(ST-16)

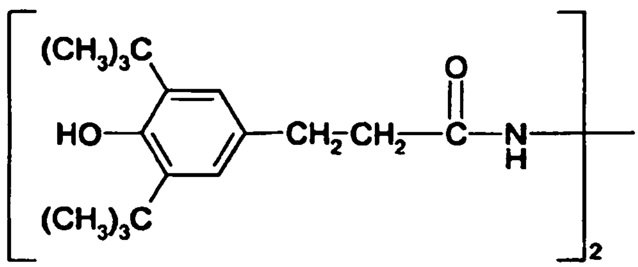

(ST-17)

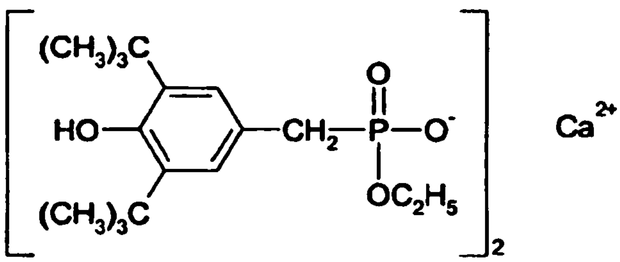

(ST-18)

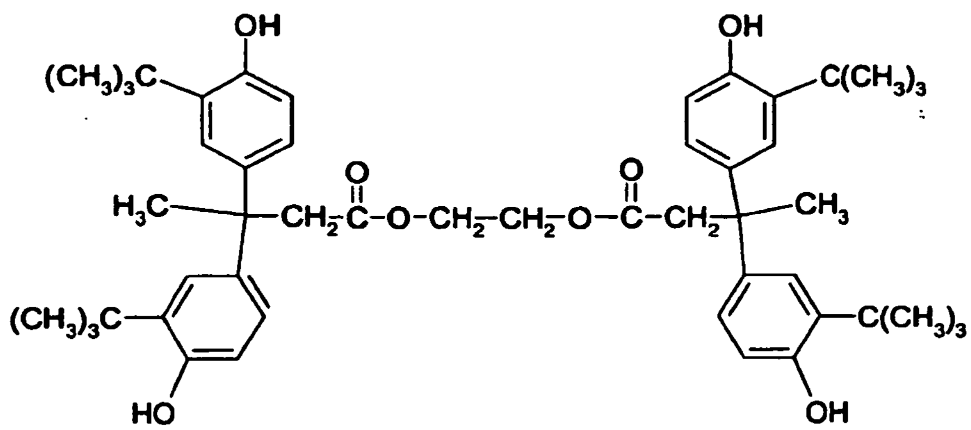

II) phenoles

(ST-19)

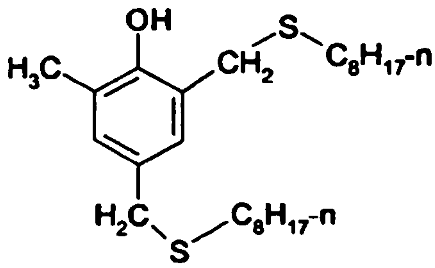

(ST-20)

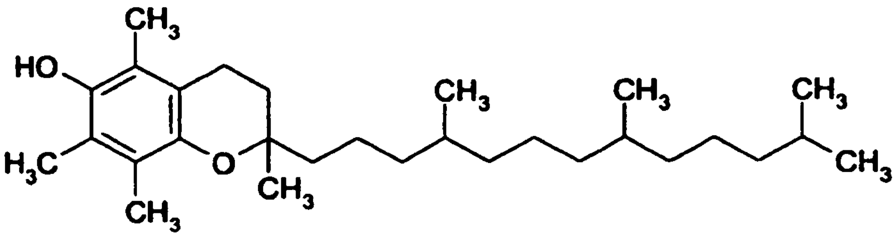

III) o-alkylated hydroquinones

(ST-21)

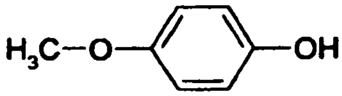

IV) Organic phosphites

(ST-22)

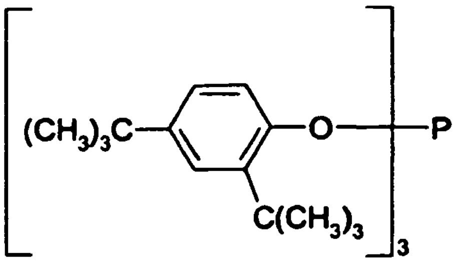

(ST-23)

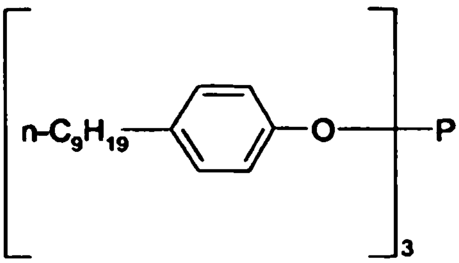

(ST-24)

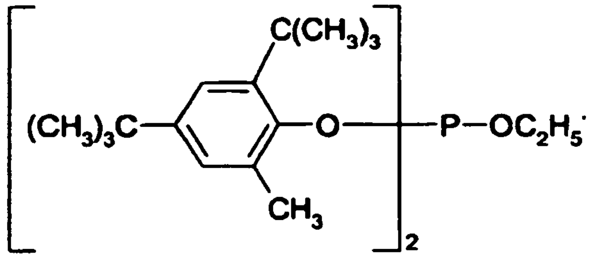

(ST-25)

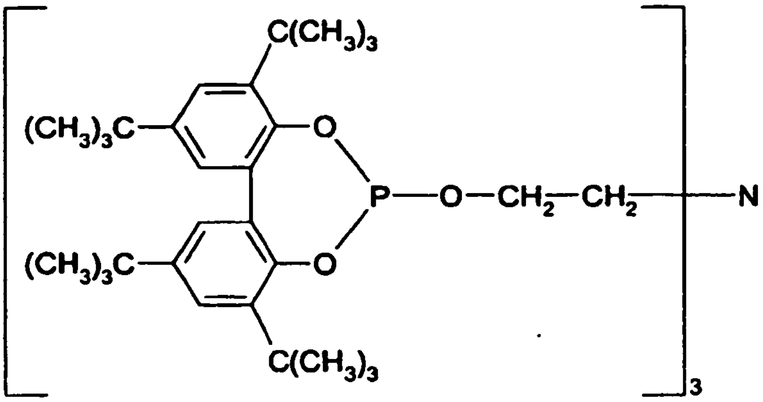

(ST-26)

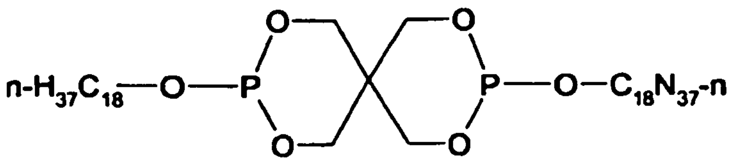

(ST-27)

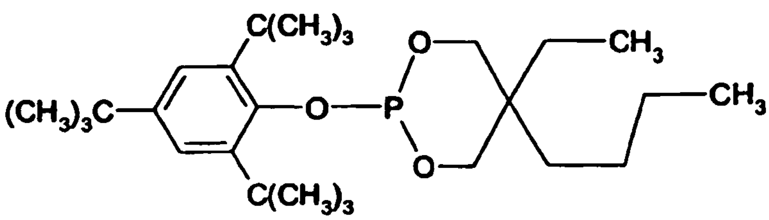

(ST-28)

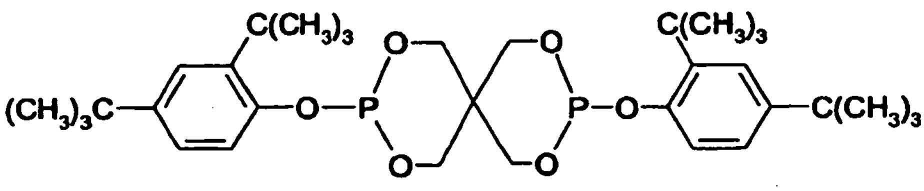

(ST-29)

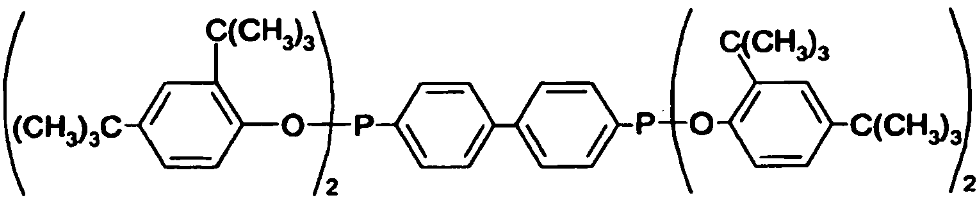

(ST-30) 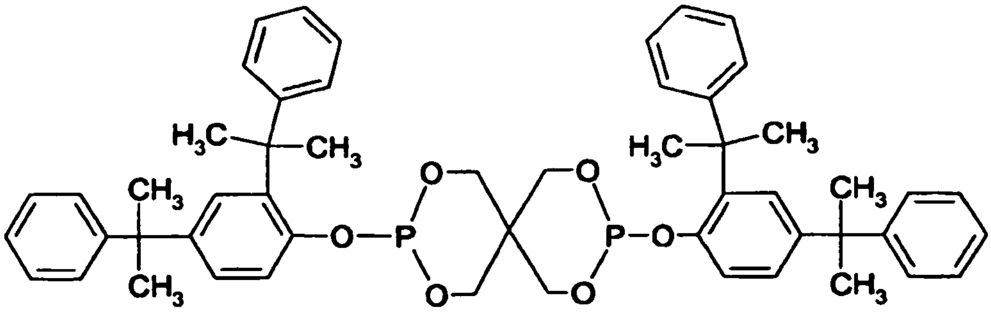

V) Organic phosphonites

(ST-31) 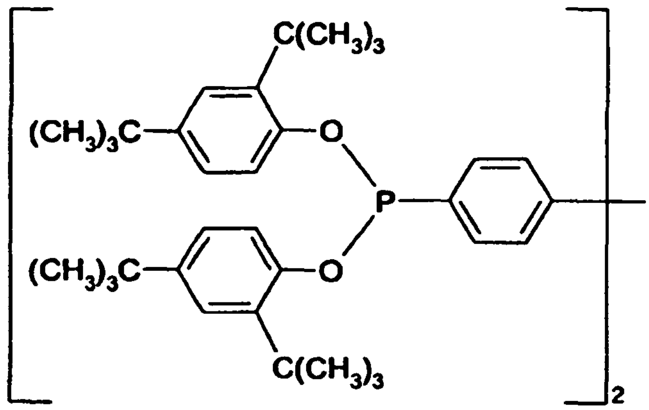

(ST-32) 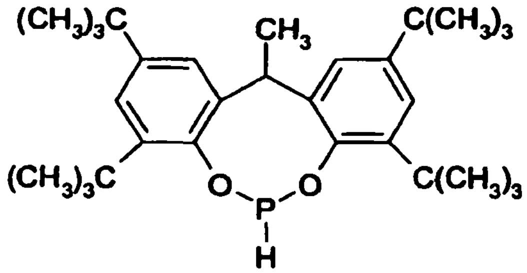

VI) Aromatic amines

(ST-33) 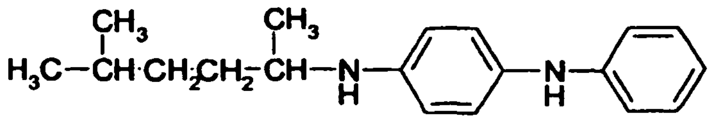

(ST-34) 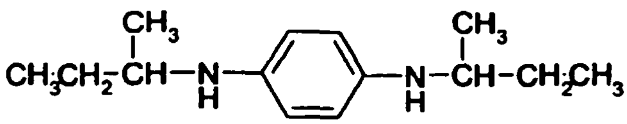

(ST-35)

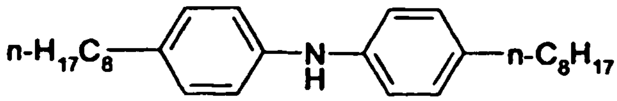

(ST-36)

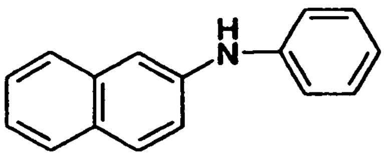

(ST-37)

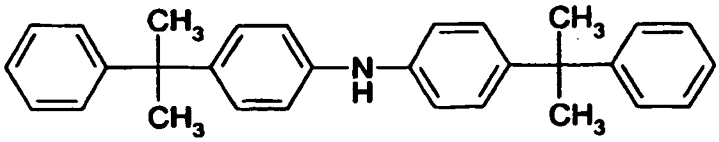

(ST-38)

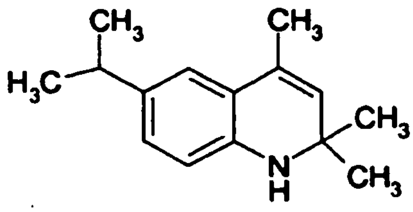

(ST-39)

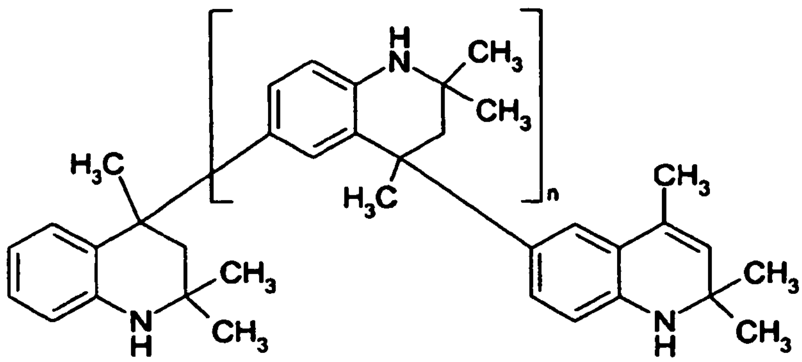

n = 0 to 6

VII) Hindered amines

(ST-40)

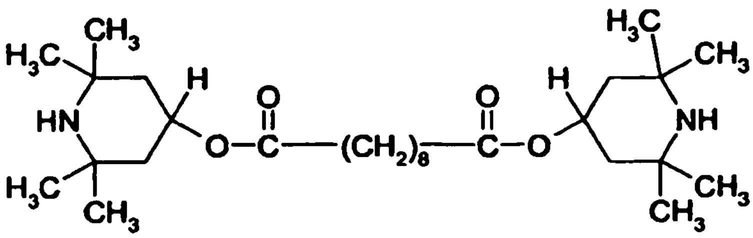

(ST-41)

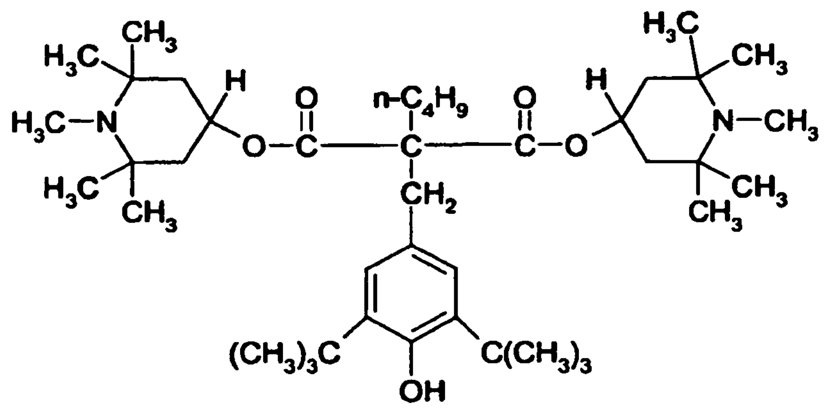

(ST-42)

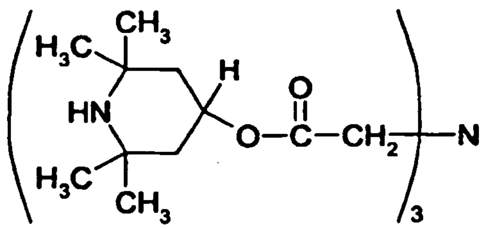

(ST-43)

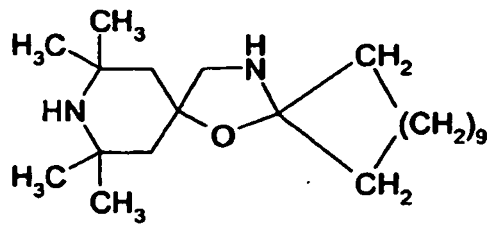

(ST-44)

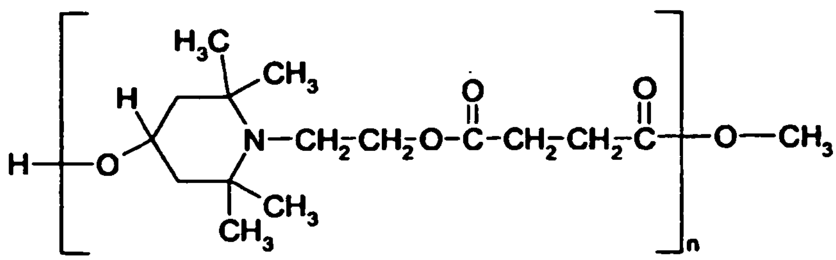

(ST-45)

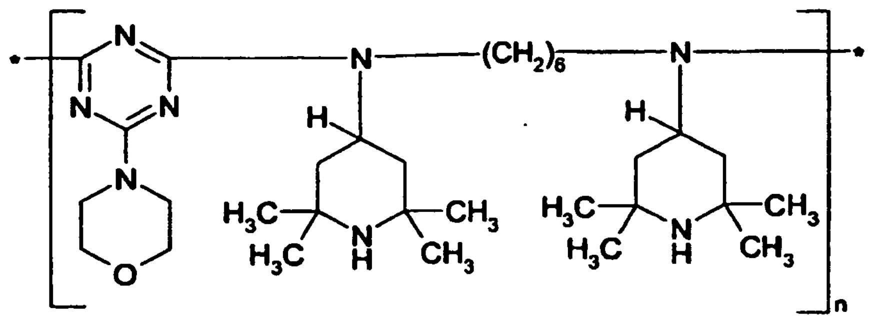

(ST-46)

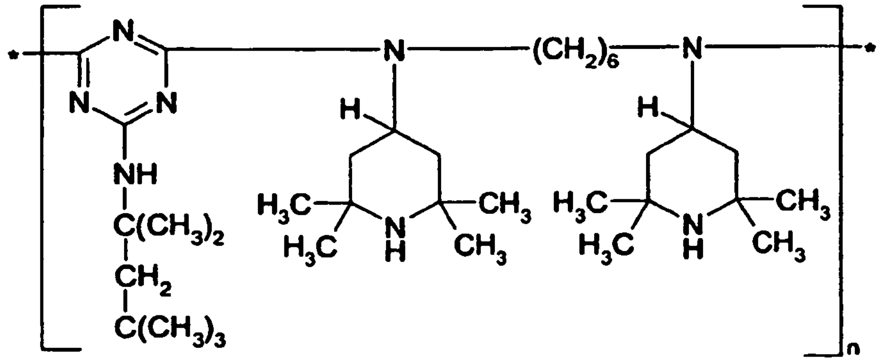

(ST-47)

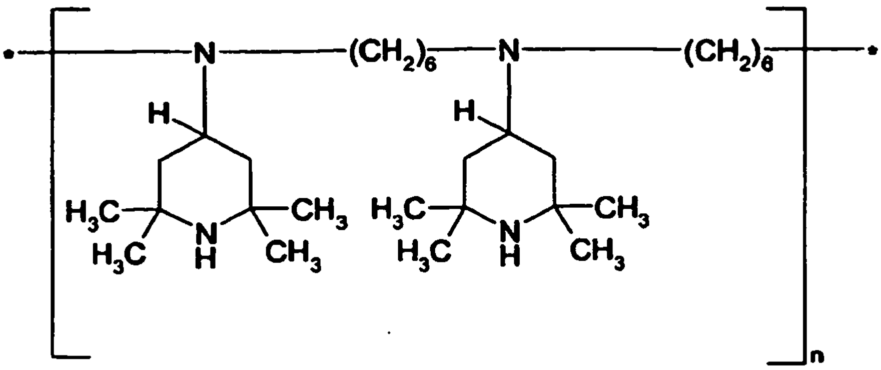

VIII) Benzofuranones (lactones)

(ST-48)

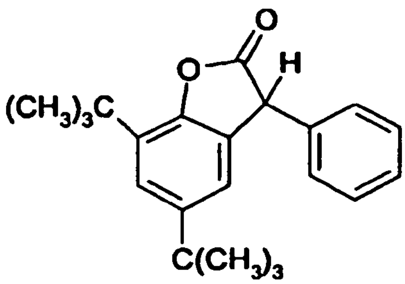

IX) Dialkyl thiodipropionates

(ST-49)

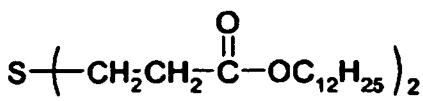

X) Metal complexants

(ST-50) 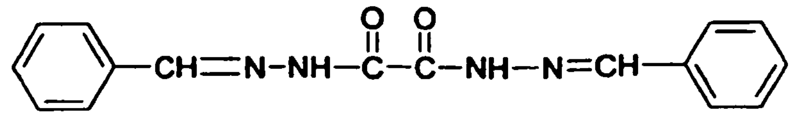

(ST-51) 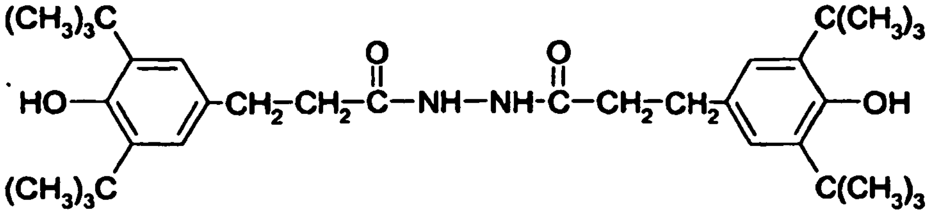

(ST-52) 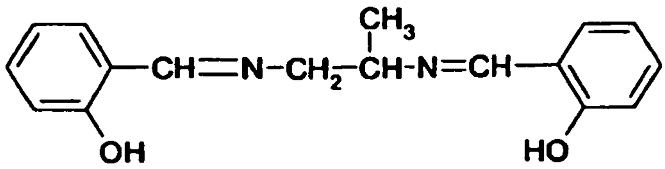

(ST-53) 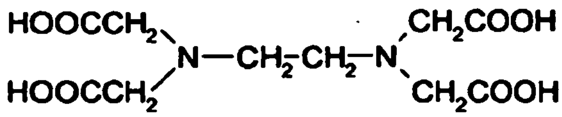

Further examples of radical stabilizers according to the present invention are butylated hydroxyanisole, 3-tert-butyl-4-methoxyphenol, n-propyl gallate (3,4,5-trihydroxybenzoic acid propyl ester), pyrogallol (1,2,3-trihydroxybenzene), t-butyl catechol (t-butyl brenzcatechine), benzochinone, citric acid, N-nitrosophenylhydroxylamine and salts thereof.

The radical stabilizers according to the present invention are preferably incorporated in the photopolymerizable composition in an amount of 0.01 to 5 wt.%, in particular from 0.015 to 3 wt.%, with respect to the total weight of the non-volatile compounds of the photopolymerizable composition.

A sensitizing dye (sensitizer) preferably used in the present invention, when incorporated in the photopolymerizable composition, has an absorption wavelength ranging from 300 to 450 nm, preferably from 350 to 430 nm and particularly preferred from 360 to 420 nm, and makes the photopolymer printing plate sensitive to light within said wavelength ranges.

In a preferred embodiment of the present invention, a sensitizer having a solubility in methyl ethyl ketone of at least 15 g/kg, preferably from 15 to 250 g/kg, measured at 20°C is used. Using such highly soluble sensitizers results in a higher $T_{max}$('asteroid'-free) and in a material having less pinhole defects. Defects called pinholes are areas having lateral dimensions of about 50 to 500 μm on the processed printing plate, that don't take up ink and therefore result in exposed areas that don't print. This unfavourable effect is particularly noticeable, if the printing plate precursor is stored before exposure and processing thereof.

The known sensitizing dyes can be used in the composition of the present invention. Suitable classes include dialkylaminobenzene compounds like (Ia) and (Ib)

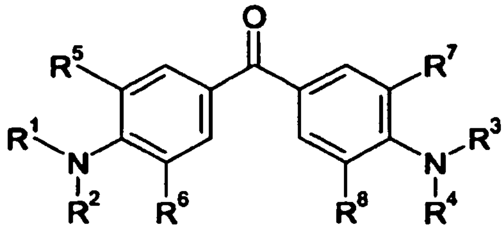 (Ia)

wherein each of $R^1$ to $R^4$, which are independent of one another, is an alkyl group having 1 to 6 carbon atoms ($C_{1-6}$ alkyl group), and each of $R^5$ to $R^6$ is a hydrogen atom or a $C_{1-6}$ alkyl group, provided that $R^1$ and $R^2$, $R^3$ and $R^4$, $R^1$ and $R^5$, $R^2$ and $R^6$, $R^3$ and $R^7$, or $R^4$ and $R^8$, may be bonded to each other to form a ring;

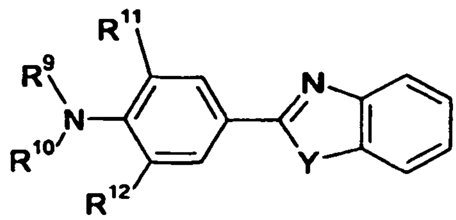

(Ib)

wherein each of $R^9$ and $R^{10}$, which are independent of each other, is a $C_{1-6}$ alkyl group, each of $R^{11}$ and $R^{12}$, which are independent of each other, is a hydrogen atom or a $C_{1-6}$ alkyl group, Y is a sulfur atom, an oxygen atom, dialkylmethylene or -N($R^{13}$)-, and $R^{13}$ is a hydrogen atom or a $C_{1-6}$ alkyl group, provided that $R^9$ and $R^{10}$, $R^9$ and $R^{11}$, or $R^{10}$ and $R^{12}$, may be bonded to each other to form a ring, as disclosed in EP 1 148 387 A1; compounds according to formula (II)

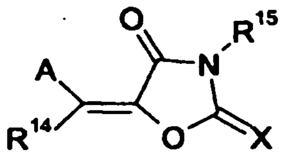

(II),

wherein A represents an optionally substituted aromatic ring or heterocyclclic ring, X represents an oxygen atom, a sulfur atom or -N($R^{16}$)-, $R^{14}$, $R^{15}$ and $R^{16}$ each independently represent a hydrogen atom or a monovalent nonmetallic atom group and A and $R^{14}$, or $R^{15}$ and $R^{16}$ can be linked together to form an aliphatic or an aromatic ring, as disclosed in EP 1 280 006 A2; 1,3-dihydro-1-oxo-2H-indene compounds as disclosed in EP 1 035 435 A2; the sensitizing dyes disclosed in EP 1 048 982 A1, EP 985 683 A1, EP 1 070 990 A1 and EP 1 091 247 A2; and / or an optical brightening agent.

To achieve a very high sensitivity, an optical brightening agent as a sensitizer is preferred. A typical optical brightener, also known as "fluorescent whitening agent", is a colorless to weakly colored organic compound that is capable of absorbing light having a wavelength in the range from 300 to 450 nm and of emitting the absorbed energy as fluorescent light having a wavelength in the range between 400 and 500 nm. A description of the physical principle and the chemistry of optical brighteners is given in Ullmann's Encyclopedia of Industrial Chemistry, Sixth Edition, Electronic Release, Wiley-VCH 1998. Basically, suitable optical brightener contain n-electron systems comprising a carbocyclic or a heterocyclic nucleus. Suitable representatives of these compounds are e. g. stilbenes, distyrylbenzenes, distyrylbiphenyls, divinylstilbenes, triazinylaminostilbenes, stilbenyltriazoles, stilbenylnaphthotriazoles, bis-triazolstilbenes, benzoxazoles, bisphenylbenzoxazoles, stilbenylbenzoxazoles, bis-benzoxazoles, furans, benzofurans, bis-benzimidazoles, diphenylpyrazolines, diphenyloxadiazoles, coumarins, naphthalimides, xanthenes, carbostyrils, pyrenes and 1,3,5-triazinyl-derivatives.

More specifically, optical brightening agent having a structure according to one of the following formulae are suitable as sensitizer for use in the composition of the present invention :

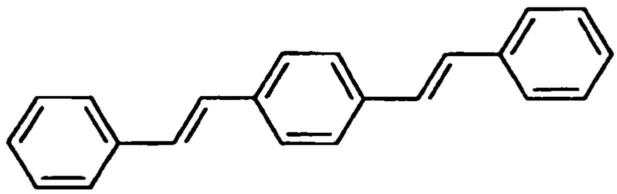

(III)

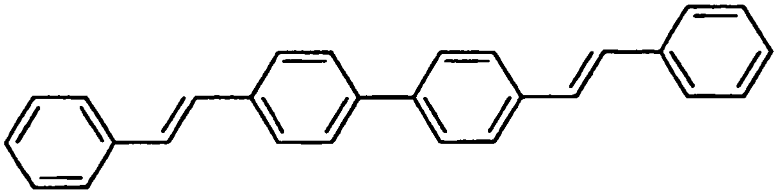

(IV)

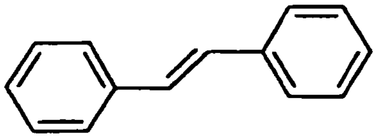

(V)

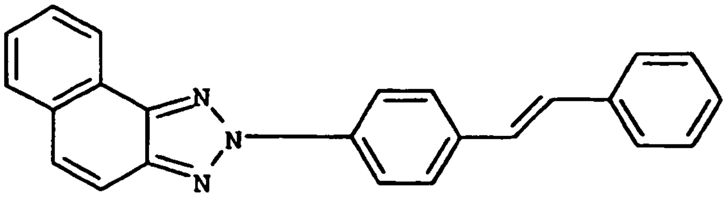

(VI)

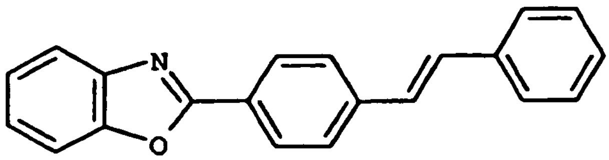

(VII)

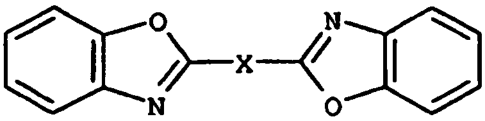

(VIII)

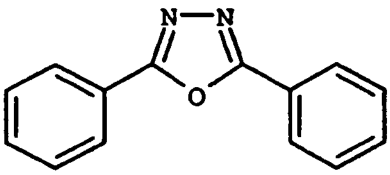

(IX)

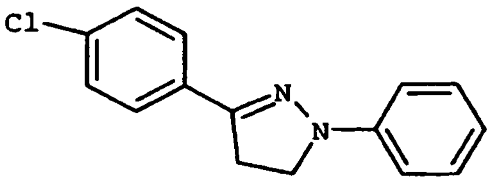

(X)

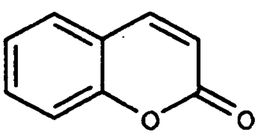

(XI)

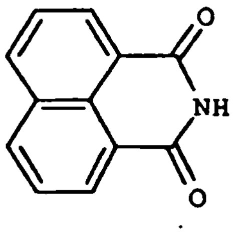

(XII)

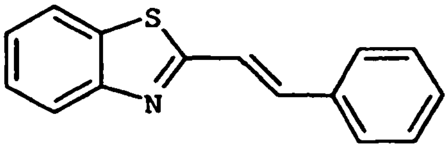

(XIII)

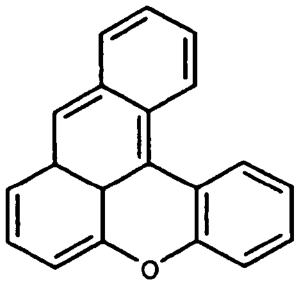

(XIV)

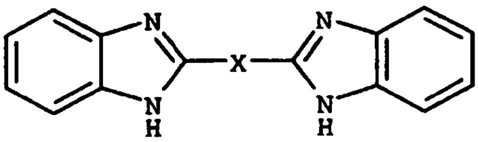

(XV)

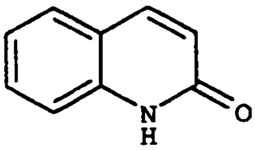

(XVI)

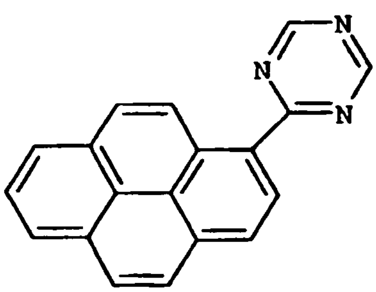

(XVII)

wherein X is one of the following groups, * denoting the position of attachment in the above formulae :

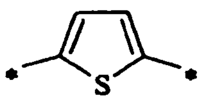

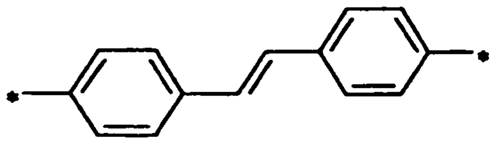

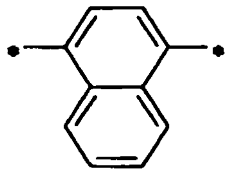

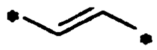

and wherein one or more of the nuclei in each of the above formulae (III) to (XVII) may be independently substituted by one or more groups selected from alkyl, alkoxy, alkylcarbonyl, alkoxycarbonyl, acyloxy, carboxyl, nitrile, amino, hydroxyl, alkylsulfonyl and aminosulfonyl.

Especially suitable optical brighteners are compounds, which are able to be dissolved in organic solvents. The optical brighteners can be used as single compound or as mixture of several materials. The overall amount of these compounds range from 0.1 to 10 % by weight, preferably 0.5 to 8 % by weight with respect to the total weight of the non-volatile compounds in the photopolymerizable composition.

Highly preferred optical brighteners include compounds of formula (III-A) to (VIII-A):

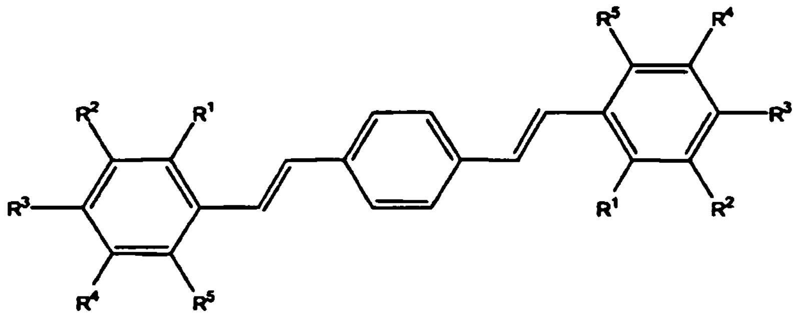

**(III-A)**

wherein

a) $R^1$ represents methyl, and $R^2$ to $R^5$ each represent H,
b) $R^2$ to $R^4$ represent methoxy, and $R^1$ and $R^5$ represent H,
c) $R^1$ represents CN, and $R^2$ to $R^5$ each represent H or
d) $R^3$ represents CN, and $R^1$, $R^2$, $R^4$ and $R^5$ each represent H;

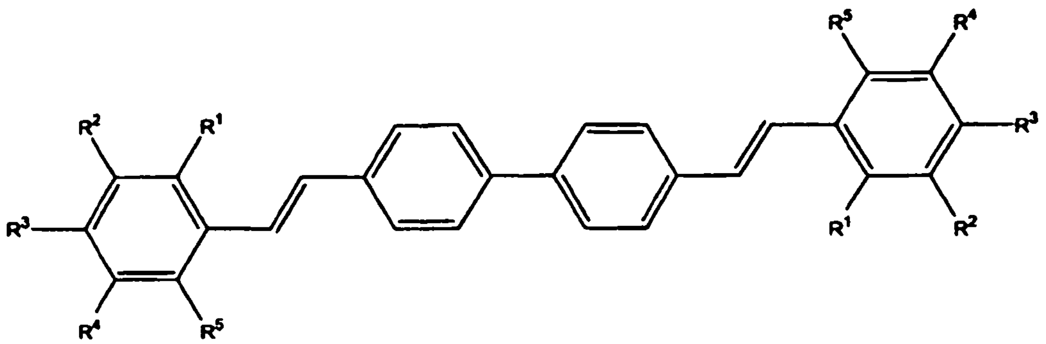

**(IV-A)**

wherein $R^1$ to $R^4$ each represent H, and $R^5$ represents methoxy;

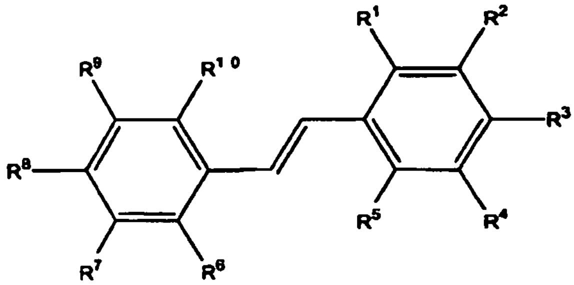

(V-A)

wherein

a) $R^1$ to $R^{10}$ each represent H,
b) $R^1$, $R^2$ and $R^4$ to $R^{10}$ each represent H, and $R^3$ represents methoxy or
c) $R^1$, $R^2$, $R^4$ to $R^7$, $R^9$ and $R^{10}$ each represent H, and $R^3$ and $R^8$ each represent methoxy;

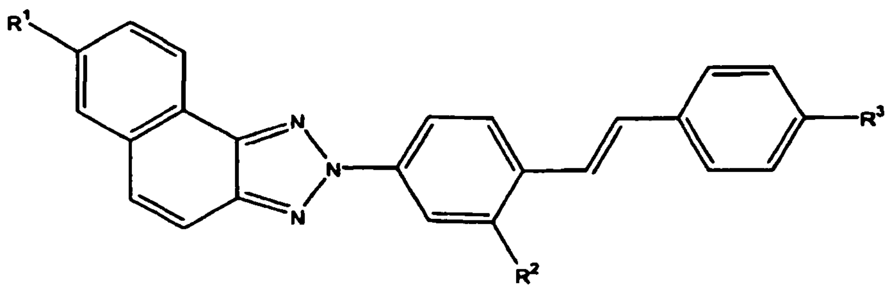

(VI-A)

wherein

a) $R^1$ and $R^3$ represent H, and $R^2$ represents phenylsulfonic acid or phenylsulfonic acid salts or
b) $R^3$ represents H, $R^2$ represents CN and $R^3$ represents C1;

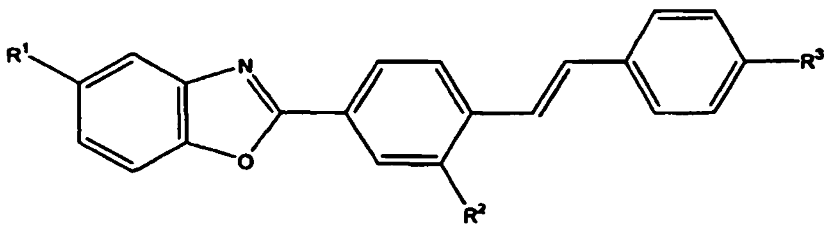

(VII-A)

wherein

a) $R^1$ represents t-butyl, $R^2$ represents H and $R^3$ represents phenyl,
b) $R^1$ represents methyl, $R^2$ represents H, and $R^3$ represents carboxymethyl or
c) $R^1$ represents H, $R^2$ represents H, and $R^3$ represents 2-(4-methyl-oxa-3,3-diazole);

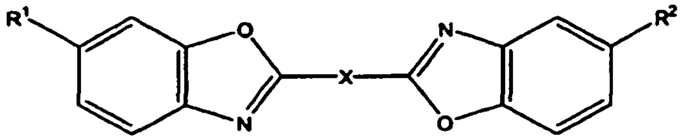

(VIII-A)

wherein

a) X represents 4,4'-stilbenediyl, and $R^3$ and $R^2$ each represent H,
b) X represents 2,5-thiophenediyl, and $R^1$ and $R^2$ each represent t-butyl,
c) X represents 1,4-naphthalenediyl, and $R^1$ and $R^2$ each represent H or
d) X represents 1,1-ethenediyl, and $R^1$ and $R^2$ each represent methyl;

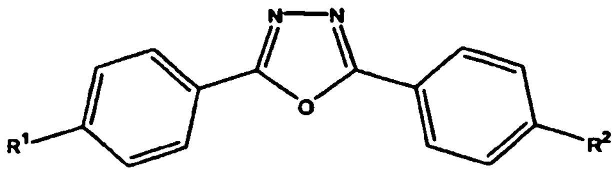

(IX-A)

wherein $R^1$ and $R^2$ each represent diethylamino:

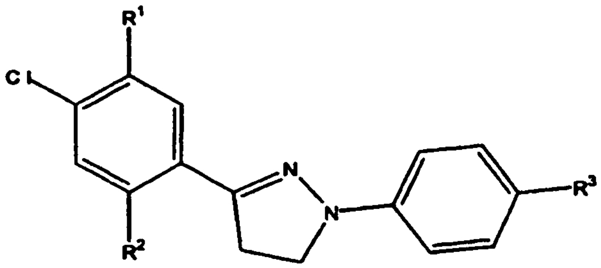

(X-A)

wherein

a) $R^1$ and $R^2$ each represent H, and $R^3$ represents $SO_2NH_2$,
b) $R^1$ and $R^2$ each represent H, and
$R^3$ represents $SO_2CH_2CH_2OCH_2CH_2N(CH_3)_2$,
c) $R^1$ and $R^2$ each represent H, and
$R^3$ represents $SO_2CH_2CH_2OCH\ (CH_3)CH_2N(CH_3)_2$,
d) $R^1$ and $R^2$ each represent H; and $R^3$ represents $SO_2CH_3$ or
e) $R^3$ and $R^2$ each represent H, and $R^3$ represents $SO_2CH_2CH_2OH$;

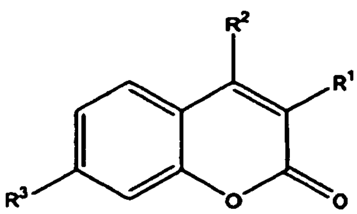

(XI-A)

wherein

a) $R^1$ represents H, $R^2$ represents Me, and $R^3$ represents diethylamino,
b) $R^1$ represents phenyl, $R^2$ represents H, and
$R^3$ represents 2-N-naphthatriazolyl,
c) $R^1$ represents H, $R^2$ represents methyl, and $R^3$ represents OH,
d) $R^1$ represents phenyl, $R^2$ represents H,
and $R^3$ represents NH-(4,6-dichloro)-(1,3,5)-triazine or e) $R^3$ represents Ph, $R^2$ represents H, and
$R^3$ represents 1-(3-methylpyrazolinyl);

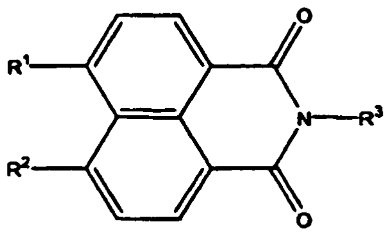

(XII-A)

wherein

a) $R^1$ represents H, $R^2$ represents methoxy, and $R^3$ represents methyl; or
b) $R^1$ and $R^2$ each represent OEt, and $R^3$ represents methyl;

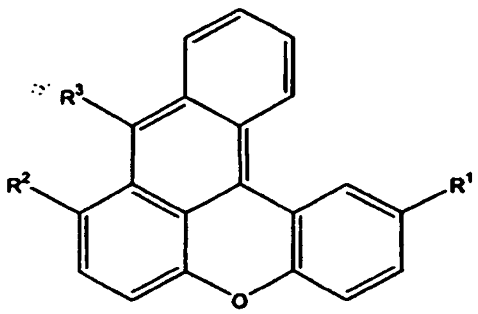

(XIV-A)

wherein

a) $R^1$ and $R^2$ each represent methyl, and $R^3$ represents H or
b) $R^1$ and $R^2$ each represent methyl, and $R^3$ represents carboxymethyl;

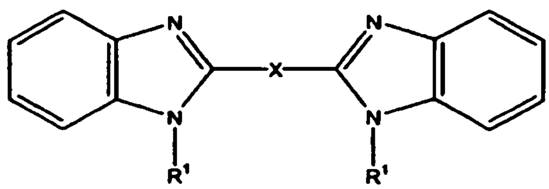

(XV-A)

wherein

a) X represents 1,2-ethenediyl, and $R^2$ represents Me or
b) X represents 4,4'-stilbenediyl, and $R^1$ represents methyl;

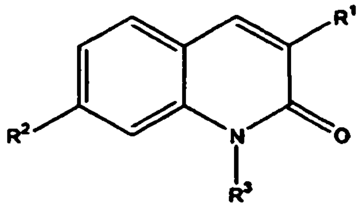

(XVI-A)

wherein $R^1$ represents Ph, $R^2$ represents diethylamino, and $R^3$ represents ethyl; and

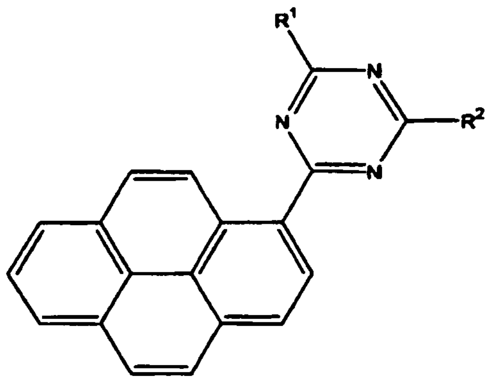

(XVII-A)

wherein $R^1$ and $R^2$ each represent methoxy.

From those sensitizers, the following compounds of formulae (IIIa) and/or (IVa) are particularly preferred:

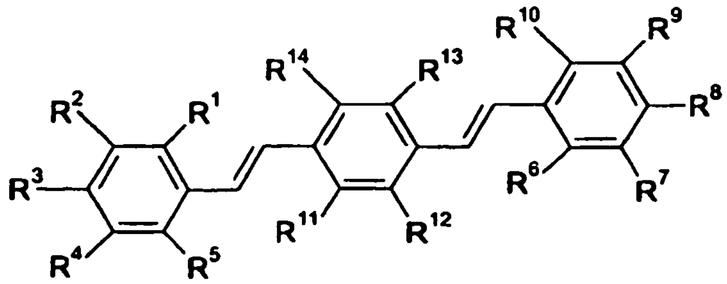

(IIIa),

wherein

$R^1$ to $R^{14}$ in dependently represent a hydrogen atom, an alkyl group, an alkoxy group, a cyano group or a halogen atom, and at least one of $R^1$ to $R^{10}$ represents an alkoxy group having more than 1 carbon atom;

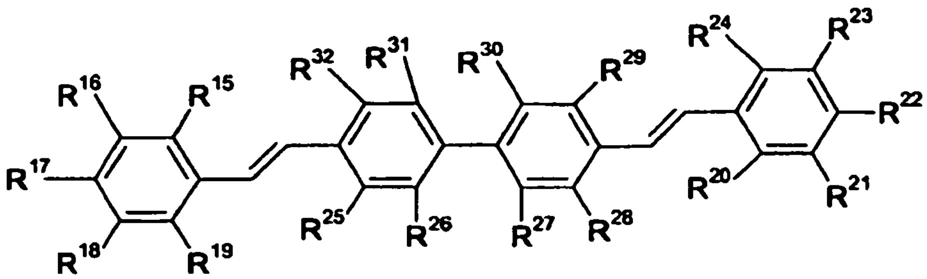

(IVa),

wherein

$R^{15}$ to $R^{32}$ independently represent a hydrogen atom, an alkyl group, an alkoxy group, a cyano group or a halogen atom, and at least one of $R^{15}$ to $R^{24}$ represents an alkoxy group having more than 1 carbon atom. The alkyl and alkoxy groups of the present invention can be optionally substituted and their substituent can be selected to adjust the solubility of the sensitizer and may be, for example, halogen, ester, ether, thioether or hydroxy. The alkyl or alkoxy groups may be straight chain or cyclic, but a branched chain is preferred for the sensitizers of formulae (IIIa) and (IVa).

Particular advantages are achieved with sensitisers of formula (IIIa), wherein $R^1$, $R^5$, $R^6$, $R^{10}$, $R^{11}$, $R^{12}$, $R^{13}$ and $R^{14}$ independently represent a hydrogen atom, a fluorine atom or a chlorine atom, in particular $R^1$, $R^5$, $R^6$, and $R^{10}$ being a hydrogen atom; $R^2$ to $R^4$, $R^7$ to $R^9$, independently are alkoxy groups; and at least two of the alkoxy groups are branched and have from 3 to 15 carbon atoms. Especially preferred for the present invention are sensitizers of formulae (IIIa) as disclosed above, wherein $R^2$, $R^4$, $R^7$, $R^9$ independently represent a methoxy group and $R^3$ and $R^8$ independently are branched alkoxy groups having 3 to 15 carbon atoms.

Particular advantages are also achieved with sensitisers of formula (IVa), wherein $R^{15}$, $R^{19}$, $R^{20}$, $R^{24}$, $R^{25}$ to $R^{32}$, independently represent a hydrogen atom, a fluorine atom or a chlorine atom, in particular $R^{15}$, $R^{19}$, $R^{20}$, $R^{24}$ being a hydrogen atom; $R^{16}$ to $R^{18}$, $R^{21}$ to $R^{23}$, independently are alkoxy groups; and at least two of the alkoxy groups are

branched and have from 3 to 15 carbon atoms. Especially preferred for the present invention are sensitizers of formulae (IVa) as disclosed above, wherein $R^{16}$, $R^{18}$, $R^{21}$, $R^{23}$ independently represent a methoxy group and $R^{17}$ and $R^{22}$ independently are branched alkoxy groups having 3 to 15 carbon atoms.

The following structures are examples of preferred sensitizers of the present invention and their solubility S is given in brackets as g sensitizer/kg methyl ethyl ketone measured at 20°C.

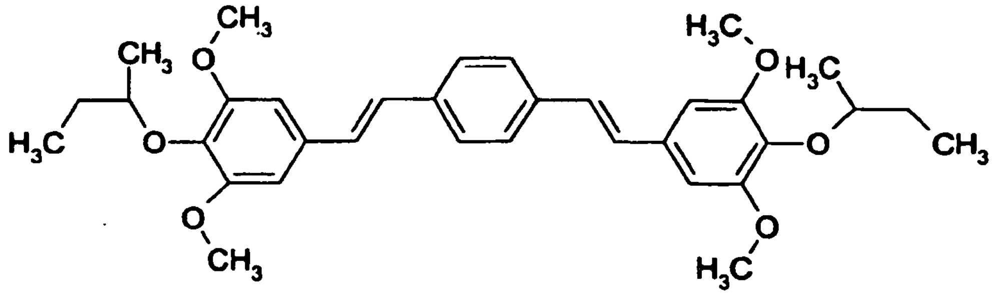

(III-1) [S = 40]

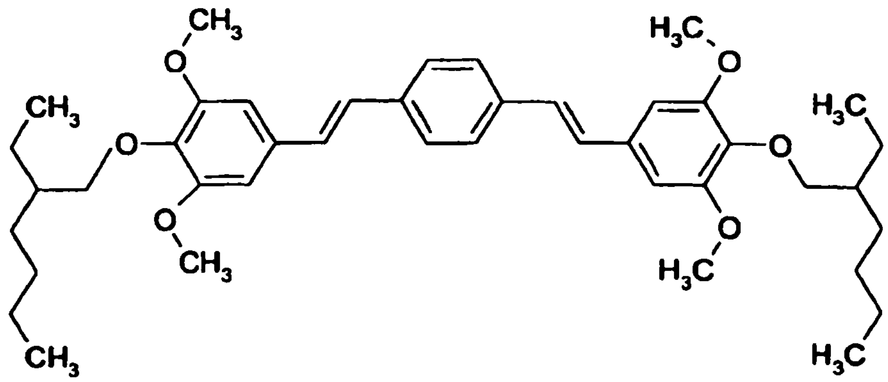

(III-2) [S = 200]

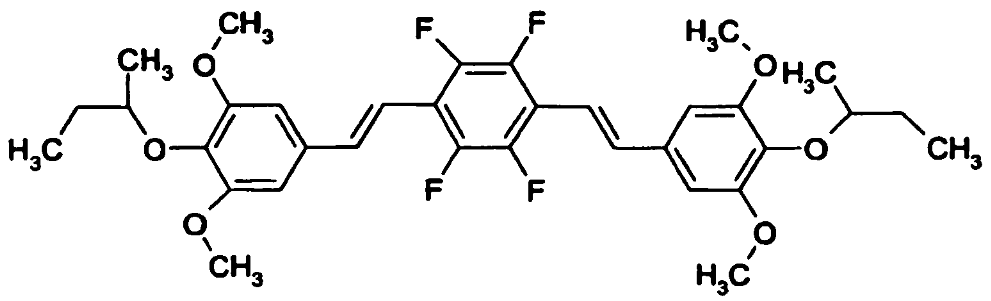

(III-3) [S = 40]

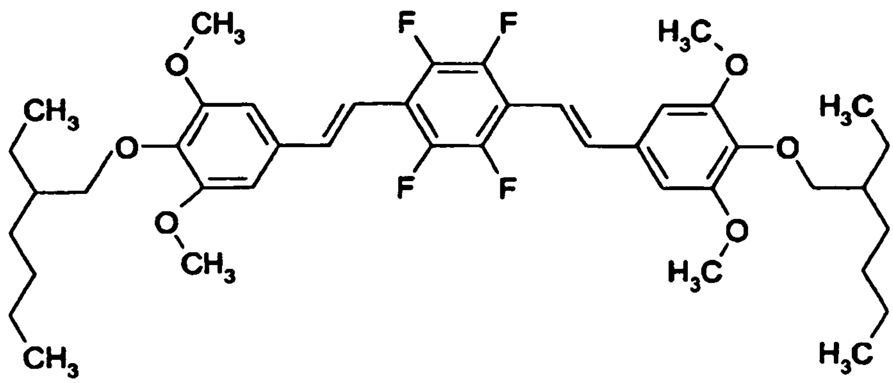

(III-4) [S = 200]

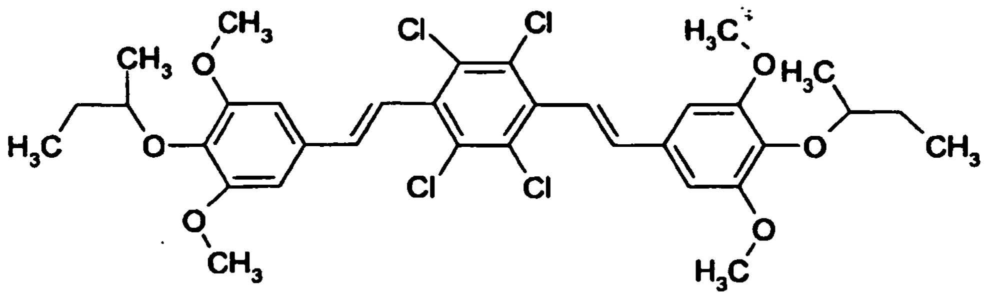

(III-5)
[S = 8]

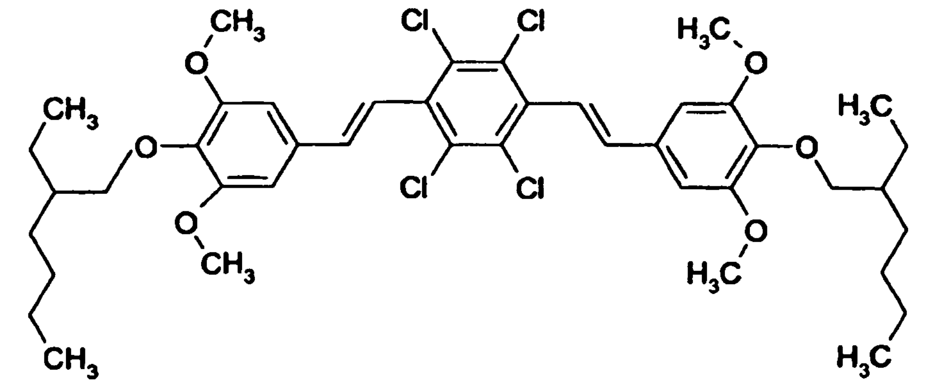

(III-6)
[S = 60]

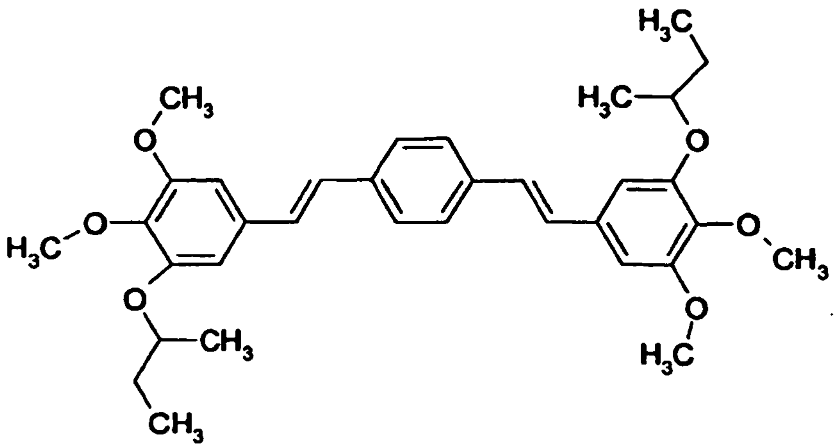

(III-7)

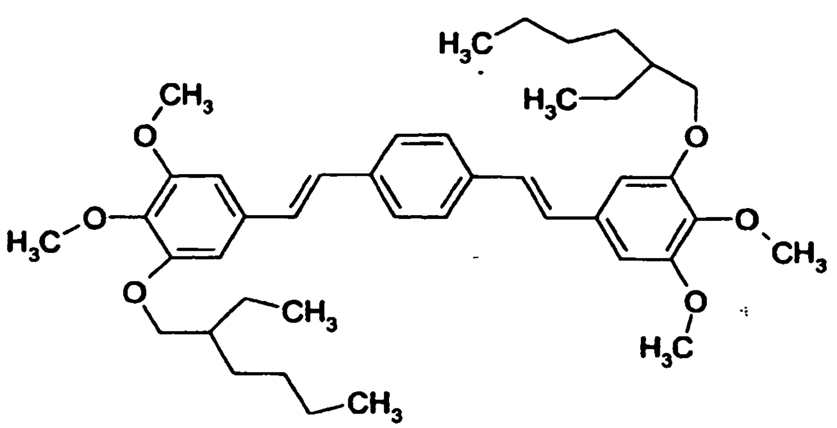

(III-8)

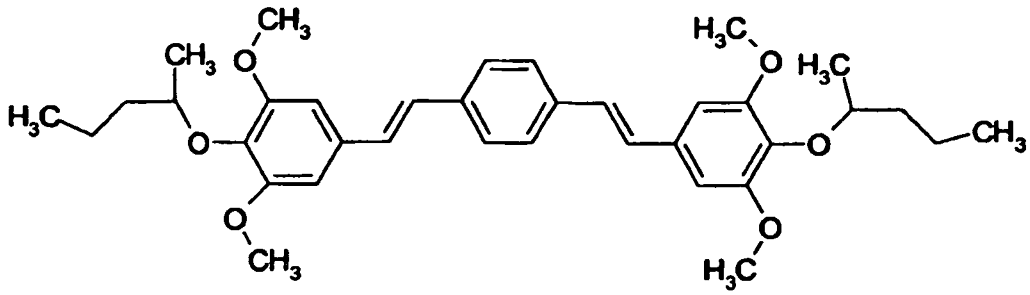

(III-9) [S = 60]

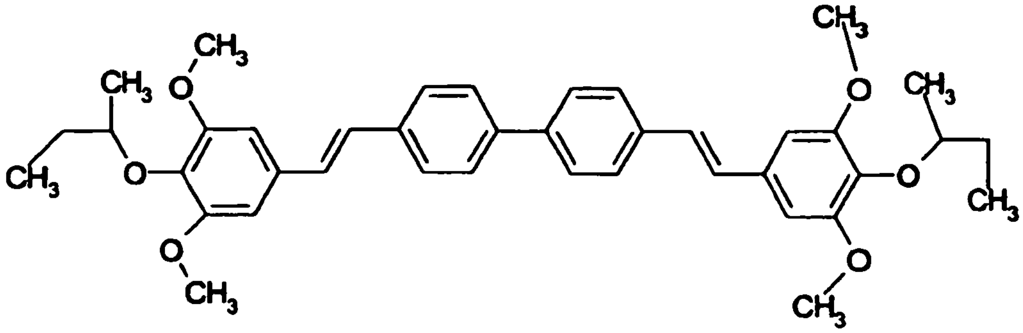

(IV-1) [S = 80]

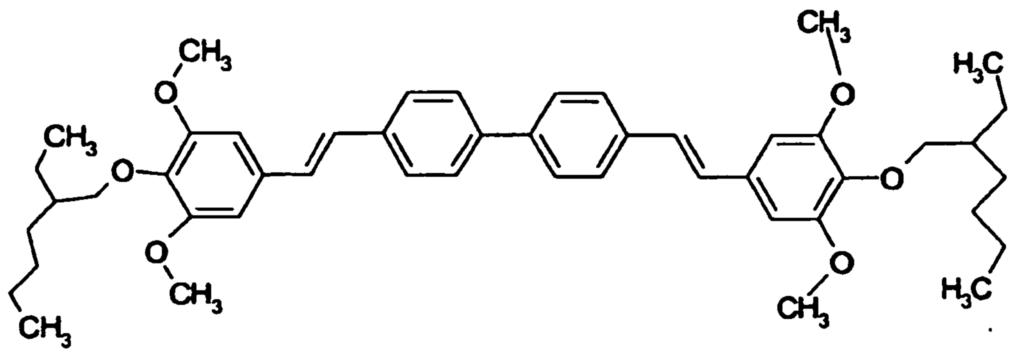

(IV-2) [S = 150]

Most sensitizers useful for the present invention can be synthesised by known methods and the synthesis of the highly preferred sensitizers of formulae (IIIa) and (IVa) can be done in analogy to the synthesis of sensitizer (III-1) as disclosed in the following.

<u>**Synthesis of intermediate (C-3)**</u>

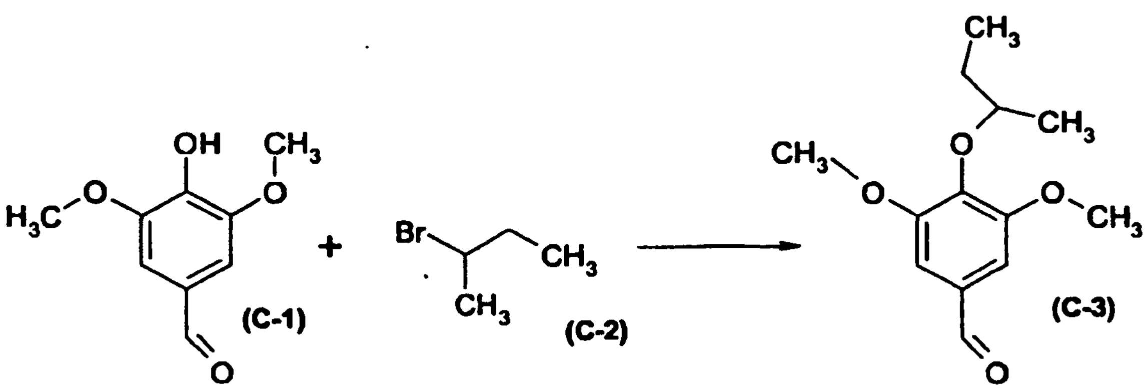

(C-1) (C-2) (C-3)

To a mixture of 8.365 kg (45.0 mol) syringaldehyde (C-1) and 1.494 kg (9.0 mol) potassium iodide is added 20.25 L sulfolane at room temperature. After heating up this mixture to 30°C under nitrogen, 3.12 kg (47.25 mol) of KOH in water and 2.80 kg (20.25 mol) $K_2CO_3$ are added. After warming the reaction mixture to 75°C, 12.78 kg (90.0 mol) 2-bromo butane (C-2) is added over a period of 30 minutes. Heating at 75°C is continued for 24 hours, followed by cooling to 25°C. Then 25 L Water is added and the reaction product is extracted with 18 L methyl t-butyl ether (MTBE). The organic phase is consecutively a) two times washed with 6.0 L of a 7.5 wt.% $K_2CO_3$ solution in water respectively, b) two times washed with 13.5 L of pure water respectively and finally, c) two times washed with 4.5 kg of a 20 wt.% NaCl solution in water respectively. The solvent (MTBE) is removed by distillation under reduced pressure of 50 mBar at 75°C and thereby are obtained 7.845 kg (theoretical yield of 75 %) of the crude intermediate **(C-3)** as a yellow oil, that is used in the synthesis of **(III-1)** without further purification.

<u>**Synthesis of sensitizer (III-1)**</u>

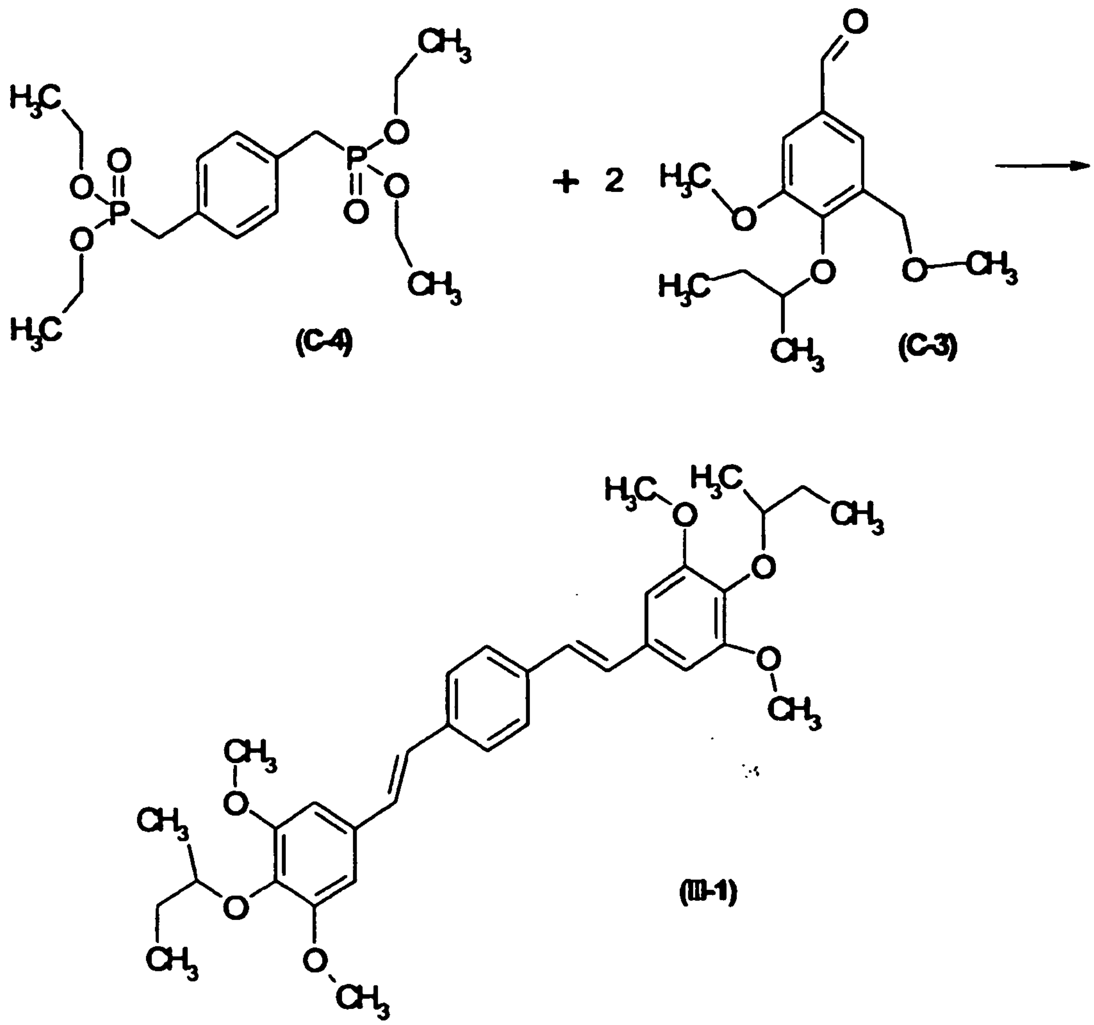

(C-4) + 2 (C-3)

(III-1)

To a mixture of 9.63 kg (25.46 mol) p-xylylene-bis-phosphonate **(C-4)** and 12.13 kg (50.92 mol) of the crude intermediate **(C-3)** in 20 L THF, 4.70 kg (71.3 mol) of KOH is added at room temperature. After heating the stirred reaction mixture at reflux for 3.5 hours, the reaction product is precipitated by adding a mixture of 25.2 kg methanol and 9.9 kg water, followed by further cooling to 20°C. The crystalline product **(III-1)** is filtered off, washed with several portions of methanol/water on the filter and dried at 50°C. The yield is 9.05 kg (theoretical yield of 67 %) of **(III-1)** having a melting point of 154°C.

A suitable synthesis for the p-xylylene-bis-phosphonate **(C-4)** is known from the literature, e.g. from B.P. Lugovkin and B.A. Arbuzov, Doklady Akademii Nauk SSSR (1948), 59, pages 1301 to 1304.

The photopolymerizable composition according to the present invention comprises a hexaarylbisimidazole

(HABI; dimer of triarylimidazole) compound as a photopolymerization initiator.

A procedure for the preparation of hexaarylbisimidazoles is described in DE 1470 154 and their use in photopolymerizable compositions is documented in EP 24 629, EP 107 792, US 4 410 621, EP 215 453 and DE 3 211 312. Preferred derivatives are e. g. 2,4,5,2',4',5'-hexaphenylbisimidazole, 2,2'-bis(2-chlorophenyl)-4,5,4',5'-tetraphenylbisimidazole, 2,2'-bis(2-bromophenyl)-4,5,4',5'-tetraphenylbisimidazole, 2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,2'-bis(2-chlorophenyl)-4,5,4',5'-tetrakis(3,4,5-trimethoxyphenyl)bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole and 2,2'-bis(2,6-difluorophenyl)-4,5,4',5'-tetraphenylbisimidazole. The amount of the HABI photoinitiator typically ranges from 0.01 to 30 % by weight, preferably from 0.5 to 20 % by weight, relative to the total weight of the non volatile components of the photopolymerizable composition.

The best results, in particular the highest sensitivity, can be obtained by the combination of an optical brightener as sensitizer and a hexaarylbisimidazole as photoinitiator, sensitizers of formulae (III) and (IV) being particularly preferred.

Hexaarylbisimidazole compounds can be used as photoinitiators in combination with further photoinitiators. The known photopolymerization initiators can be used in the composition of the present invention in combination with hexarylbisimidazole compounds. Suitable classes include aromatic ketones, aromatic onium salts, organic peroxides, thio compounds, ketooxime ester compounds, borate compounds, azinium compounds, metallocene compounds, active ester compounds and compounds having a carbon-halogen bond. Many specific examples of such photoinitiators can be found in EP-A 1091247.

Preferably hexaarylbisimidazole compounds are used alone or in combination with aromatic ketones, aromatic onium salts, organic peroxides, thio compounds, ketoxime ester compounds, borate compounds, azinium compounds, active ester compounds or compounds having a carbon halogen bond.

In a preferred embodiment of the present invention the hexaarylbisimidazole compounds make more than 50 mol-%, preferably at least 80 mol-% and particularly preferred at least 90 mol-% of all the photoinitiators used in the photopolymerizable composition of the present invention.

The binder can be selected from a wide series of organic polymers. Compositions of different binders can also be used. Useful binders include for example chlorinated polyalkylenes in particular chlorinated polyethylene and chlorinated polypropylene; poly(methacrylic acid) alkyl esters or alkenyl esters in particular poly(methyl (meth)acrylate), poly (ethyl (meth)acrylate), poly(butyl (meth)acrylate), poly(isobutyl (meth)acrylate), poly(hexyl (meth)acrylate), poly((2-ethylhexyl) (meth)acrylate) and poly(alkyl (meth)acrylate); copolymers of (meth)acrylic acid alkyl esters or alkenyl esters with other copolymerizable monomers, in particular with (meth)acrylonitrile, vinyl chloride, vinylidene chloride, styrene and/or butadiene; poly(vinyl chloride) (PVC); vinylchloride/(meth)acrylonitrile copolymers; poly(vinylidene chloride) (PVDC); vinylidene chloride/(meth)acrylonitrile copolymers; poly(vinyl acetate); poly(vinyl alcohol); poly (meth)acrylonitrile; (meth) acrylonitrile/styrene copolymers; (meth)acrylamide/alkyl (meth)acrylate copolymers; (meth)acrylonitrile/butadiene/styrene (ABS) terpolymers; polystyrene; poly($\alpha$-methylstyrene); polyamides; polyurethanes; polyesters; cellulose or cellulose compounds like methyl cellulose, ethyl cellulose, acetyl cellulose, hydroxy-($C_{1-4}$-alkyl)cellulose, carboxymethyl cellulose; poly(vinyl formal) and poly(vinyl butyral). Particularly suitable are binders that are insoluble in water, but on the other hand are soluble or at least swellable in aqueous-alkaline solutions. Further effective binders are polymers that are soluble in common organic coating solvents.

Particular suitable for the purpose of the present invention are binders containing carboxyl groups, in particular polymers or copolymers containing monomeric units of alpha,beta-unsaturated carboxylic acids and/or monomeric units of alpha,beta-unsaturated dicarboxylic acids, preferably acrylic acid, methacrylic acid, crotonic acid, vinylacetic acid, maleic acid or itaconic acid. By the term "copolymers" are to be understood in the context of the present invention polymers containing units of at least 2 different monomers, thus also terpolymers and higher mixed polymers. Particular useful examples of copolymers are those containing units of (meth)acrylic acid and units of alkyl (meth)acrylates, allyl (meth)acrylates and/or (meth)acrylonitrile as well as copolymers containing units of crotonic acid and units of alkyl (meth) acrylates and/or (meth)acrylonitrile and vinylacetic acid/alkyl (meth)acrylate copolymers. Also suitable are copolymers containing units of maleic anhydride or maleic acid monoalkyl esters. Among those are, for example, copolymers containing units of maleic anhydride and styrene, unsaturated ethers or esters or unsaturated aliphatic hydrocarbons and the esterification products obtained from such copolymers. Further suitable binders are products obtainable from the conversion of hydroxyl-containing polymers with intramolecular dicarboxylic anhydrides. Further useful binders are polymers in which groups with acid hydrogen atoms are present, some or all of which are converted with activated isocyanates. Examples of these polymers are products obtained by conversion of hydroxyl-containing polymers with aliphatic or aromatic sulfonyl isocyanates or phosphinic acid isocyanates. Also suitable are polymers with aliphatic or aromatic hydroxyl groups, for example copolymers containing units of hydroxyalkyl (meth)acrylates, allyl alcohol, hydroxystyrene or vinyl alcohol, as well as epoxy resins, provided they carry a sufficient number of free OH groups.

The organic polymers used as binders have a typical mean molecular weight $M_w$ between 600 and 200 000,

preferably between 1 000 and 100 000. Preference is further given to polymers having an acid number between 10 to 250, preferably 20 to 200, or a hydroxyl number between 50 and 750, preferably between 100 and 500. The amount of binder(s) generally ranges from 10 to 90 % by weight, preferably 20 to 80 % by weight, relative to the total weight of the non-volatile components of the composition.

The polymerizable compound can be selected from a wide series of photo-oxidizable compounds. Suitable compounds contain primary, secondary and in particular tertiary amino groups. Radically polymerizable compounds containing at least one urethane and/or urea group and/or a tertiary amino group are particularly preferred. By the term "urea group" has to be understood in the context of the present invention a group of the formula >N-CO-N<, wherein the valences on the nitrogen atoms are saturated by hydrogen atoms and hydrocarbon radicals (with the proviso that not more than one valence on either of the two nitrogen atoms is saturated by one hydrogen atom). However, it is also possible for one valence on one nitrogen atom to be bonded to a carbamoyl (-CO-NH-) group, producing a biuret structure.

Also suitable are compounds containing a photo-oxidizable amino, urea or thio group, which may be also be a constituent of a heterocyclic ring. Compounds containing photo-oxidizable enol groups can also be used. Specific examples of photo-oxidizable groups are triethanolamino, triphenylamino, thiourea, imidazole, oxazole, thiazole, acetylacetonyl, N-phenylglycine and ascorbic acid groups. Particularly suitable compounds are monomers containing photo-oxidizable groups corresponding to the following formula (XVIII):

$$R_{(m-n)}Q[(-CH_2-CR^1R^2-O)_a-CO-NH-(X^1-NH-CO-O)_b-X^2-(O-CO-CR^3=CH_2)_c]_n \quad (XVIII)$$

wherein

- R represents an alkyl group having 2 to 8 carbon atoms (($C_2$-$C_8$) alkyl group), a ($C_2$-$C_8$) hydroxyalkyl group or a ($C_6$-$C_{14}$) aryl group,
- Q represents -S-,

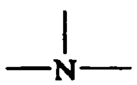 , 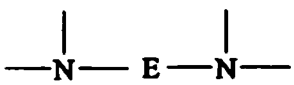 or 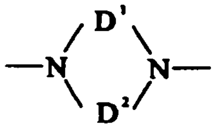

  wherein
  E represents a divalent saturated hydrocarbon group of 2 to 12 carbon atoms, a divalent 5- to 7-membered, saturated iso- or heterocyclic group, which may contain up to 2 nitrogen, oxygen and/or sulfur atoms in the ring, a divalent aromatic mono- or bicyclic isocyclic group of 6 to 12 carbon atoms or a divalent 5- or 6-membered aromatic heterocyclic group; and
  $D^1$ and $D^2$ independently represent a saturated hydrocarbon group of 1 to 5 carbon atoms,
- $R^1$ and $R^2$ independently represent a hydrogen atom, an alkyl or alkoxyalkyl group,
- $R^3$ represents a hydrogen atom, a methyl or ethyl group,
- $x^1$ represents a straight-chained or branched saturated hydrocarbon group of 1 to 12 carbon atoms,
- $x^2$ represents a (c+1)-valent hydrocarbon group in which up to 5 methylene groups may have been replaced by oxygen atoms,
- a is an integer from 0 to 4,
- b is 0 or 1,
- c is an integer from 1 to 3,
- m is an integer from 2 to 4 and
- n is an integer from 1 to m.

Compounds of this nature and processes for their preparation are described in EP 287 818. If a compound of general formula (XVIII) contains several radicals R or several radicals according to the structure indicated between square brackets, i. e. if (n-m) > 1 and n>1, these radicals can be identical or different from one another. Compounds according to formula (XVIII) wherein n = m are particularly preferred. In this case, all radicals contain polymerizable groups. Preferably, the index a is 1; if several radicals are present, a cannot be 0 in more than one radical. If R is an alkyl or hydroxyalkyl group, R generally contains 2 to 6, particularly 2 to 4 carbon atoms. Aryl radicals R are in general mononuclear or binuclear, preferably however mononuclear, and may be substituted with ($C_1$-$C_5$) alkyl or ($C_1$-$C_5$) alkoxy groups. If $R^1$ and $R^2$ are alkyl or alkoxy groups, they preferably contain 1 to 5 carbon atoms. $R^3$ is preferably a hydrogen atom or a methyl group. $X^1$ is preferably a straight-chained or branched aliphatic and/or cycloaliphatic radical of preferably 4 to 10 carbon atoms. In a preferred embodiment, $X^2$ contains 2 to 15 carbon atoms and is in particular a saturated, straight-chained or branched aliphatic and/or cycloaliphatic radical containing this amount of carbon atoms. Up to 5 methylene groups in these radicals may have been replaced by oxygen atoms; in the case of $X^2$ being composed of pure carbon chains, the radical generally has 2 to 12 carbon atoms, preferably 2 to 6 carbon atoms. $X^2$ can also be a cycloaliphatic group of 5 to 10 carbon atoms, in particular a cyclohexane diyl group. The saturated heterocyclic ring formed by $D^1$, $D^2$ and both nitrogen atoms generally has 5 to 10 ring members in particular 6 ring members. In the latter case the heterocyclic ring is preferably a piperazine and the radical derived therefrom a piperazine-1,4-diyl radical. In a preferred embodiment, radical E is an alkane diyl group which normally contains about 2 to 6 carbon atoms. Preferably the divalent 5- to 7-membered, saturated, isocyclic group E is a cyclohexane diyl group, in particular a cyclohexane-1,4-diyl group. The divalent, isocyclic, aromatic group E is preferably an ortho-, meta- or para-phenylene group. The divalent 5- or 6-membered aromatic heterocyclic group E, finally, contains preferably nitrogen and/or sulphur atoms in the heterocyclic ring. c is preferably 1, i. e. each radical in the square bracket generally contains only one polymerizable group, in particular only one (meth)acryloyloxy-group.

The compounds of formula (XVIII) wherein b = 1, which accordingly contain two urethane groups in each of the radicals indicated in the square brackets, can be produced in a known way by conversion of acrylic esters or alkacrylic esters which contain free hydroxyl groups with equimolar amounts of diisocyanates. Excess isocyanate groups are then, for example, reacted with tris(hydroxyalkyl)amines, N,N'-bis(hydroxyalkyl) piperazines or N,N,N',N'-tetrakis(hydroxyalkyl)alkylenediamines, in each of which individual hydroxyalkyl groups may have been replaced by alkyl or aryl groups R. If a = 0, the result is a urea grouping. Examples of the hydroxyalkylamine starting materials are diethanolamine, triethanolamine, tris(2-hydroxypropyl)amine, tris(2-hydroxybutyl)amine and alkyl-bis-hydroxyalkylamines. Examples of suitable diisocyanates are hexamethylene diisocyanate, 2,2,4-trimethylhexamethylene diisocyanate, 1,4-cyclohexylene diisocyanate (= 1,4-diisocyanatocyclohexane) and 1,1,3-trimethyl-3-isocyanatomethyl-5-isocyanatocyclohexane. The hydroxy-containing esters used are preferably hydroxyethyl (meth)acrylate, hydroxypropyl (meth)acrylate and hydroxyisopropyl (meth)acrylate.

The polymerizable compounds of formula (XVIII) wherein b = 0 are prepared converting the above-described hydroxyalkylamino compounds with isocyanate-containing acrylic or alkacrylic esters. A preferred isocyanate-containing ester is isocyanoto-ethyl (meth)acrylate.

Further polymerizable compounds comprising photooxidisable groups suitable for the purpose of the invention are compounds according to the following formula (XIX):

$$R_{(m-n)}Q[(-CH_2-CR^1R^2-O)_a-(CH_2-CH[CH_2-O-CO-CR^3=CH_2]-O)_b-H]_n \qquad (XIX)$$

wherein a' and b' independently represent integers from 1 to 4 and Q, $R^1$, $R^2$, $R^3$, n and m have the same meaning as above and Q can also be a group of the formula >N-E'-N< wherein the radical E' corresponds to the following formula (XX) :

$$-CH_2-CH(OH)-CH_2-[O-(p)C_6H_4-C(CH_3)_2-(p)C_6H_4-CH_2-CH(OH)-CH_2-]_c \qquad (XX)$$

wherein c has the same meaning as in formula (I) and $(p)C_6H_4$ represents para-phenylene.

The compounds of formula (XIX) can be prepared analogously to those of formula (XVIII), except that the conversion products of hydroxyalkyl acrylates or alkacrylates and diisocyanates are replaced by the corresponding acrylic and alkacrylic glycide esters. Compounds of formula (XX) and processes to their preparation are disclosed in EP 316 706.

Further useful polymerizable compounds containing photooxidisable groups are acrylic and alkacrylic esters of the following formula (XXI) :

$$Q'[(-X^1-CH_2-O)_a-CO-NH(-X^1-NH-CO-O)_b-X^2-O-CO-CR^3=CH_2]_n \qquad (XXI)$$

wherein

Q' represents

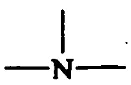 , 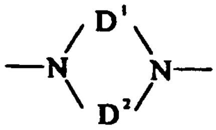 or 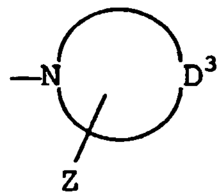

wherein $D^1$ and $D^2$ independently represent a saturated hydrocarbon group of 1 to 5 carbon atoms and $D^3$ represents a saturated hydrocarbon group of 4 to 8 carbon atoms, which together with the nitrogen atom forms a 5- or 6-membered heterocyclic ring;

$X^{1'}$ represents $-C_1H_{21}-$ or

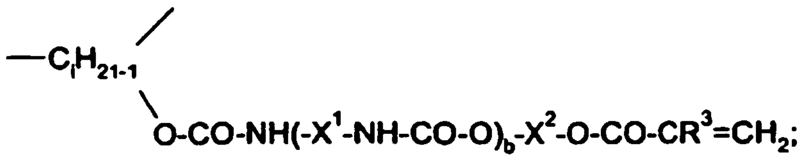

Z represents a hydrogen atom or a radical of the following formula: $-C_kH_{2k}-O-CO-NH\ (-X^1-NH-CO-O)_b-X^2-O-CO-CR^3=CH_2$ ;

i,k independently represent integers from 1 to 12;

n' represents an integer from 1 to 3; and

a is 0 or 1; provided that a is 0 in at least one of the radicals bonded to Q;

$X^1$, $R^3$, a and b have the same meaning as given in the above formula (VIII); and

$X^2$ represents a divalent hydrocarbon group in which up to 5 methylene groups may be replaced by oxygen atoms.

In formula (XXI) index a is preferably 0 or 1 and i preferably represents a number between 2 and 10. Preferred radicals Q are piperazine-1,4-diyl ($D^1 = D^2 = CH_2-CR_2$), piperidine-1-yl ($D^3 = (CH_2)_5$, Z = H) and 2-(2-hydroxyethyl)-piperidine-1-yl ($D^3 = (CH_2)_5$, $Z = CH_2CH_2OH$).

Of the compounds of formula (XXI), those which apart from a urea group contain at least one urethane group are preferred. Here again, by the term "urea group" has to be understood the group of formula >N-CO-N< already mentioned above. Compounds of formula (XXI) and processes for their preparation are disclosed in EP 355 387.

Also suitable polymerizable compounds are reaction products of mono- or diisocyanates with multifunctional alcohols, in which the hydroxy groups are partly or completely esterified with (meth)acrylic acid. Preferred compounds are materials, which are synthesized by the reaction of hydroxyalkyl-(meth)acrylates with diisocyanates. Such compounds are basically known and for instance described in DE 28 22 190 and DE 20 64 079.

The amount of polymerizable compound comprising photooxidisable groups generally ranges from 5 to 75 % by weight, preferably from 10 to 65 % by weight, relative to the total weight of the non volatile compounds of the photopolymerizable composition.

Moreover, the composition can contain polyfunctional (meth)acrylate or alkyl(meth)acrylate compounds as crosslinking agents. Such compounds contain more than 2, preferably between 3 and 6 (meth)acrylate and/or alkyl (meth)acrylate groups and include in particular (meth)acrylates of saturated aliphatic or alicyclic trivalent or polyvalent alcohols such as trimethylol ethane, trimethylol propane, pentaerythritol or dipentaerythritol.

The total amount of polymerizable compounds generally ranges from about 10 to 90 % by weight, preferably from about 20 to 80 % by weight, relative to the total weight of the non volatile components of the photopolymerizable composition of the present invention.

The following specific example is a prefered polymerizable compound:

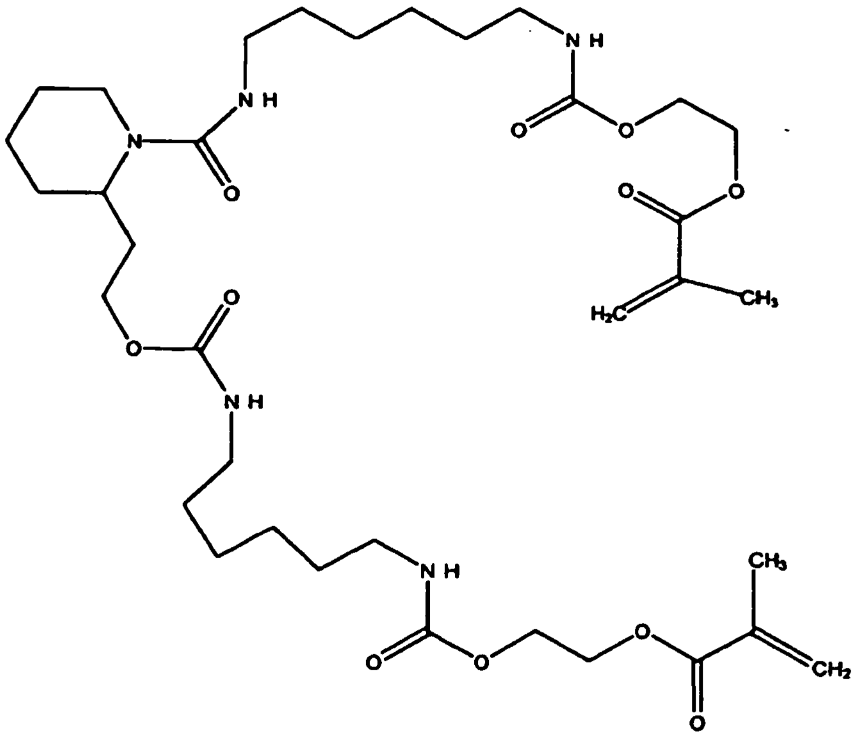

In order to achieve a high sensitivity, it is advantageous to add a radical chain transfer agent as described in EP 107 792 to the photopolymerizable composition of the present invention. The preferred chain transfer agents are sulfur containing compounds, especially thiols like e. g. 2-mercaptobenzothiazole, 2-mercaptobenzoxazole or 2-mercapto-benzimidazole. The amount of chain transfer agent generally ranges from 0.01 to 10 % by weight, preferably from 0.1 to 2 % by weight, relative to the total weight of the non volatile components of the photopolymerizable composition.

Optionally pigments, e.g. predispersed phthalocyanine pigments, can be added to the composition of the present invention for dyeing the composition and the layers produced therewith. Their amount generally ranges from about 1 to 20 % by weight, preferably from 2 to 15 % by weight and particularly preferred from about 2 to 10 % by weight related to the total weight of the non volatile components of the composition. Particularly suitable predispersed phthalocyanine pigments are disclosed in DE 199 15 717 and DE 199 33 139. Preference is given to metal-free phthalocyanine pigments.

In order to adjust the photopolymerizable composition according to the present invention to specific needs, thermal inhibitors or stabilizers for preventing thermal polymerization may be added. Furthermore additional hydrogen donors, dyes, colored or colorless pigments, color formers, indicators and plasticisers may be present. These additives are convieniently selected so that they absorb as little as possible in the actinic range of the imagewise applied radiation.

The photopolymerizable composition according to the present invention is applied to the support by processes which are known per se to the person skilled in the art. In general, the components of the photopolymerizable composition are dissolved or dispersed in an organic solvent or solvent mixture, the solution or dispersion is applied to the intended support by pouring on, spraying on, immersion roll application or in a similar and the solvents are removed during the subsequent drying.

The known supports can be used for the photopolymer printing plate of the present invention, like e. g. foils, tapes or plates made of metal or plastics and in the case of screen-printing also of Perlon gauze. Preferred metals are aluminium, aluminium alloys, steel and zinc, aluminium and aluminium alloys being particularly preferred. Preferred plastics are polyester and cellulose acetates, polyethyleneterephthalate (PET) being particularly preferred.

In most cases it is preferred, to treat the surface of the support mechanically and/or chemically and/or electrochemically to optimally adjust the adherence between the support and the photosensitive coating and/or to reduce the reflection of the imagewise exposed radiation on the surface of the support (antihalation).

The most preferred support to be used for the present invention is made of aluminium or an aluminium alloy, its surface is electrochemically roughened, thereafter anodized and optionally treated with a hydrophilizing agent like e. g. poly(vinylphosphonic acid).

The protective overcoat according to the present invention comprises at least one type of poly(vinyl alcohol), wherein the mean degree of saponification is less than 93 mol-%, preferably a mixture of at least two types of poly(vinyl alcohol) wherein the overall mean degree of saponification of all the polyvinylalcohols is less than 93 mol-%.

The degree of saponification is related to the production of poly(vinyl alcohols). As the monomer of poly(vinyl alcohol), vinyl alcohol, is nonexistent, only indirect methods are available for the production of poly(vinyl alcohol). The most important manufacturing process for poly(vinyl alcohol) is the polymerization of vinyl esters or ethers, with subsequent saponification or transesterification. The preferred starting material for the poly (vinyl alcohol) of the present invention is a vinyl alcohol esterified by a mono carboxylic acid and in particular vinyl acetate, but derivatives of vinyl acetate, vinyl esters of di carboxylic acids, vinyl ethers and the like can also be used. The degree of saponification as defined for the present invention is the molar degree of hydrolysis irrespective of the process used for the hydrolysis. Pure poly(vinyl alcohol) has e. g. a degree of saponification of 100 mol-%, but commercial products often have a degree of saponification of 98 mol-%. The poly(vinyl alcohols) as used for the present invention contain mainly 1,3-diol units, but may also contain small amounts of 1,2-diol units. In the partially saponified poly(vinyl alcohols) the ester or the ether group can be distributed statistically or blockwise. Preferred partially saponified poly(vinyl alcohols) of the present invention have a viscosity of a 4 % aqueous solution at 20°C of 4 to 60 mPa·s, preferably of 4 to 20 mPa·s and in particular of 4 to 10 mPa·s.

Poly(vinyl alcohols) preferred for the present invention are commercially available e. g. under the tradename Mowiol. Those products are characterised by two appended numbers, meaning the viscosity and the degree of saponification. For example, Mowiol 8 - 88 or Mowiol 8/88 mean a poly(vinyl alcohol) having as 4 % aqueous solution at 20°C a viscosity of ca 8 mPa·s and a degree of saponification of 88 mol-%. Although the use of only one type of poly(vinyl alcohol) is sufficient to achieve an advantage, it is preferred to use a mixture of two or more compounds, because this allows a more accurate adjustment and a better optimization of further properties of the printing plate precursor. Preferably poly(vinyl alcohols) differing in viscosity as defined above and/or in saponification degree are combined. Particularly preferred are mixture of poly(vinyl alcohols) that differ in viscosity of their 4 % aqueous solutions at 20°C for at least 2 mPa·s or that differ in saponification degree for at least 5 mol-%. Most preferred are mixtures comprising at least 3 types of poly(vinyl alcohols), wherein at least two compounds differ in viscosity as defined above for at least 2 mPa·s and at least two compounds differ in saponification degree for at least 5 mol-%.

According to a preferred embodiment of the present invention, a mixture of at least two types of polyvinylalcohol are used wherein the overall mean saponification degree of all polyvinyl alcohols used in the protective layer has to be less than 93 mol-%. Thereby is achieved a higher $T_{max}$('asteroid'-free) and also an improved pre-heat latitude with respect to the dot gain, i.e. the dot gain is less influenced by the pre-heat temperature compared to higher overall mean saponification degrees. In a particular preferred embodiment of the present invention said overall mean saponification degree ranges from 71 mol-% to less than 93 mol-% and in particular from 80 mol-% to 92,9 mol-%.

As long as said mean overall saponification limit of 93 mol-% is not reached, one of the poly(vinyl alcohols) used in a mixture can have a mean saponification degree of more than 93 mol-% and even up to 100 mol-%.

The overall mean saponification degree of the poly(vinyl alcohols) used in the protective overcoat of a printing plate precursor can be determined experimentally via $^{13}$C-NMR. To measure the $^{13}$C-NMR spectra, approximately 200 mg of the protective overcoat are dissolved in 1.0 ml DMSO and from this solution a 75 MHz $^{13}$C-NMR spectrum is taken, whose resonances can easily be interpreted and allow to calculate the degree of saponification. Such values are listed in the Examples, in Table 3, as experimental values. A good correlation is obtained between said experimental values and the values known from the product specification of the poly(vinyl alcohols). The latter values are hereinafter called theoretical values of the mean saponification degree and can easily be calculated, when mixture of poly(vinyl alcohols) are used.

Preferably poly(vinyl alcohol)s are used for the present invention in 50 to 99.9 weight percent (wt.%) relative to the total weight of the non-volatile compounds of the protective overcoat.

According to the present invention, the protective layer further contains a poly(vinyl pyrrolidone) in an amount from 0 to 10 parts by weight of the poly(vinyl alcohol) used, from 0 to 3 parts by weight being particularly preferred. Most preferred no poly(vinyl pyrrolidone)compounds are used.

Apart from poly(vinyl alcohol)s and poly(vinyl pyrrolidone), other water soluble polymers can be further added to the layer such as poly(ethylene oxide), gelatin, gum arabic, oxygen binding polymers with aliphatic amine groups known from EP 352 630 B1, methyl vinylether/maleic anhydride copolymers, poly(carboxylic acids), copolymers of ethylene oxide and poly(vinyl alcohol), carbon hydrates, hydroxy ethyl cellulose, acidic cellulose, cellulose, poly(arylic acid)and mixtures of these polymers.

In addition to the poly(vinyl alcohol) and polyvinylpyrrolidone of the present invention and the optional water-soluble polymers disclosed above, the known ingredients of protective layers can be used.

Examples of known ingredients suitable for the protective layer of the present invention are surface wetting agents, coloring agents, complexants, polyethylenimines and biocides.

The protective layer has to be transparent for actinic light. Preferably it is homogeneous, substantially impermeable to oxygen, waterpermeable, and can be washed off preferably with the conventional developer solutions used to form a printing relief after imagewise exposure of the photosensitive layer. Said photosensitive layer is removed imagewise, whereas the protective layer is removable over the entire area of the element created. The wash-off of the

protective layer can be done in a separate step, but can be done during the development step as well.

The dry coating weight of the protective overcoat can be measured by the following procedure. A plate is exposed for 4 hours to daylight. Next the plate is pre-heated between 104 °C and 127°C (temperature measured via a thermostrip (THERMAX commerically available from TMC) at the back of the plate). The plate is cut to a size of 100 mm x 100 mm and weighted on an analytical balance with 0.01 mg accuracy (=Weight A). Next the protective overcoat is washed off with water (25°C) for 2 minutes. Than the plate is rinsed with demineralised water and dried in an oven at 100°C. After drying the plate is allowed to cool down to room temperature, and the weight is determined using the same analytical balance as described earlier (=Weight B). The dry coating weight in g/m$^2$ of the protective overcoat is calculated using the formula below :

$$\text{Dry coating weight } (g/m^2) = 100 \times (\text{Weight A} - \text{Weight B})$$

The protective layer can be coated on the photosensitive layer with known techniques and the coating solution preferably contains water or a mixture of water and an organic solvent. To allow a better wetting, the coating solution preferably contains, related to the solid content, up to 10 wt.%, and particular preferred up to 5 wt.% of a surface active agent. Suitable representatives of surface active agents comprise anionic, cationic and nonionic surface active agents like sodium alkylsulfates and -sulfonates having 12 to 18 carbon atoms, an example of which is sodium dodecylsulfate, N-cetyl- and C-cetyl betaine, alkylaminocarboxylate and -dicarboxylate, and polyethylene glycols with a mean molar weight up to 400.

In addition, further functions can be added to the protective layer. For example, it can be possible to improve the safelight suitability without decreasing the sensitivity of the layer by adding a coloring agent, e. g. a water-soluble dye, that has excellent transmission to the light having a wavelength of 300 to 450 nm and that absorbs the light having a wavelength of 500 nm or more. This principle can easily be varied for different wavelengths to adjust the effective spectral sensitivity distribution of the printing plate precursor as needed.

The present invention also relates to a method of making a lithographic printing plate comprising the steps of providing a photopolymer printing plate precursor, exposing said printing plate precursor with a laser having an emission wavelength in the range from 300 to 450 nm, heating the plate to a temperature, when measured at the back of the plate, from about 90°C to 150°C, washing off the protective coating and processing the printing plate precursor in an aqueous alkaline developer

In preferred embodiment of the process of the present invention the exposure is done with a laser having an emission wavelength in the range from 380 to 430 nm, in particular in the range from 390 to 420 nm, and the exposure is carried out at an energy density, measured on the surface of the plate, of 100 $\mu J/cm^2$ or less.

The processing of the printing plate precursor of the present invention is done in the usual manner. After image-wise exposure a pre-heat step is performed to improve the crosslinking of the photosensitive layer. Usually the pre-heat step is then followed by the development step, wherein the complete overcoat layer and the unexposed part of the photosensitive layer are removed. The removal (wash-off) of the overcoat layer and the development of the photosensitive layer can be done in two separate steps in this order, but can also be done in one step simultaneously. Preferably the overcoat layer is washed-off with water before the development step. The wash-off can be done with cold water, but it is preferred to use hot water to accelerate the process. What remains on the support after the development step are the exposed and thereby photopolymerized parts of the photosensitive layer. The developer solution used for the development of the exposed printing plate precursors of the present invention preferably is an aqueous alkaline solution having a pH of at least 11, a pH from 11.5 to 13.5 being particularly preferred. The developer solution can contain a small percentage, preferably less than 5 wt.%, of an organic, water-miscible solvent. To adjust the pH of the solution, an alkali hydroxide is preferably used.

Examples of preferred, additional ingredients of the developer solution comprise alone or in combination alkali phosphates, alkali carbonates, alkali bicarbonates, an organic amine compound, alkali silicates, buffering agents, complexants, defoamers, surface active agents and dyes, but the suitable ingredients are not limited to the preferred examples and further ingredients can be used.

The method of development employed is not particularly limited, and may be conducted by soaking and shaking the plate in a developer, physically removing non-image portions while being dissolved in a developer by means of e. g. a brush, or spraying a developer onto the plate so as to remove non-image portions. The time for development is selected depending upon the above method used so that the non-image portions can adequately by removed, and is optionally selected within a range of 5 seconds to 10 minutes.

After the development, the plate my be subjected to a hydrophilic treatment by means of, e. g., gum arabic optionally applied to the printing plate as the case requires (gumming step).

## Examples

### Components used in the examples

(A) A solution containing 32.4 wt.% of a methylmethacrylate / methacrylic acid copolymer (ratio methylmethacrylate / methacrylic acid of 85:15 by weight; acid number: 110 mg KOH/g) in 2-butanone (viscosity 105 $mm^2/s$ at 25°C).
(B) A solution containing 88.2 wt.% of a reaction product from 1 mole of 2,2,4-trimethyl-hexamethylenediisocyanate and 2 moles of hydroxyethylmethacrylate (viscosity 3.30 $mm^2/s$ at 25°C).
(C) A solution in 2-butanone containing 30.1 wt.% of a reaction product from 1 mole of hexamethylenediisocyanate, 1 mole of 2-hydroxyethylmethacrylate and 0.5 mole of 2-(2-hydroxyethyl)-piperidine (viscosity 1.7 $mm^2/s$ at 25 °C).
(D) Sensitizer (III-1).
(E) Heliogene blue D 7490® dispersion (9.9 wt.%, viscosity 7.0 $mm^2/s$ at 25 °C), trade name of BASF AG, as disclosed in EP 1 072 956.
(F) 2,2'-Bis(2-chlorophenyl)-4,4',5,5'-tetraphenyl-1,2-bisimidazole.
(G) 2-Mercaptobenzothiazole.
(H) Edaplan LA 411® (commercially available from Münzig Chemie; 1 wt.% in Dowanol PM® (trade mark of Dow Chemical Company)); silicon surfactant.
(I) 2-Butanone.
(J) Propyleneglycol-monomethylether (Dowanol PM®, trade mark of Dow Chemical Company).
(K) Partially hydrolyzed poly(vinyl alcohol) (degree of saponification 88 mol-%, viscosity 4 mPa·s in an aqueous solution of 4 wt.% at 20 °C).
(L) Fully hydrolyzed poly(vinyl alcohol) (degree of saponification 98 mol-%, viscosity 6 mPa·s in an aqueous solution of 4 wt.% at 20°C).
(M) Partially hydrolyzed poly(vinyl alcohol) (degree of saponification 88 mol-%, viscosity 8 mPa·s in an aqueous solution of 4 wt.% at 20. °C).
(N) Acticide LA1206; a biocide commercially available from Thor based on a mixture of 5-chlor-2-methyl-2H-isothiazol-3-on and 2-Br-2-nitropropanediol.
(O) Metolat FC 355 (ethoxylated ethylenediamine; commercially available from Münzig Chemie):

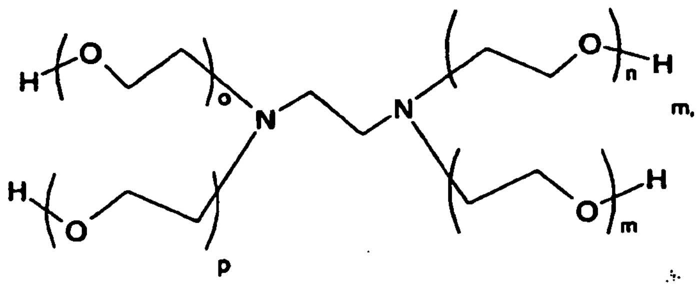

m, n, o, p = 11

(P) Lutensol A8 (90 wt.%) (surface active agent; commercially available from BASF)
(Q) Water
(R) Lupasol P (polyethylenimine 50 wt.% in water; commercially available from BASF)

### Comparative Example 1

#### A) Preparation and coating of the photosensitive layer

A composition was prepared (pw = parts per weight; wt.% = weight percentage) by mixing the ingredients as specified in table 1. This composition was coated on an electrochemically roughened and anodically oxidized aluminum sheet, the surface of which has been rendered hydrophilic by treatment with an aqueous solution of poly(vinylphosphonic acid) (oxide weight 3 $g/m^2$) and was dried at 105 °C. The resulting thickness of the layer was 1.5 $g/m^2$.

**Table 1: Composition of the photosensitive coating solution**

| Component | Parts per weight (g) |
|---|---|
| (A) | 181.70 |
| (B) | 36.14 |
| (C) | 381.23 |
| (D) | 10.97 |
| (E) | 207.11 |
| (F) | 16.58 |
| (G) | 0.77 |
| (H) | 25.50 |
| (I) | 650.07 |
| (J) | 1489.95 |

**B) Preparation and coating of the protective overcoat layer**

On top of the photosensitive layer a solution in water (containing 4.0 wt.%) of the composition as defined in table 2 was coated and then was dried at 120 °C for 2 minutes.

**Table 2: coating composition of the protective overcoat**

| Component | Parts per weight (g) |
|---|---|
| (K) | 550.67 |
| (L) | 475.82 |
| (M) | 237.91 |
| (N) | 2.56 |
| (O) | 12.11 |
| (P) | 1.03 |
| (Q) | 30719.90 |

The protective overcoat had a dry coating weight of 1.90 g/m$^2$.

**Evaluation of the pre-heat latitude**

Three plates were imaged with a 40% screen (110 1pi) at the appropriate exposure i.e. sensitivity of the plate (minimum energy density to expose 2 solid steps (0.3 optical density) of an UGRA 1982 step wedge). For this example the sensitivity is 26 μJ/cm$^2$. The imaging was carried out with an experimental violet platesetter device (flat bed system) equipped with a violet laser diode emitting between 392 to 417 nm. The following imaging conditions were used:

Scanning speed: 1000 m/s
Variable image plane power: 0 to 10.5 mW
Spot diameter: 20 μm
Addressability: 1270 dpi

After the imaging step the plate was processed in an Agfa VSP85 processor at a speed of 1.2 m/min. During the processing the plate is first heated (pre-heat step), next the protective overcoat is washed off and the photolayer is processed in a water based alkaline developer (Agfa EN 231C) at 28 °C. After a water rinsing and gumming step the printing plate is ready to use.

The three plates were processed at different pre-heat temperatures ($Tp_{re\text{-}heat}$) : 99°C. 104°C, 116°C, 121°C, 127°C, 138°C and 143°C (i.e. temperature measured at the back of the plate with a thermostrip). The temperature at

the back of the plate was varied by varying the temperature of the ceramic heater of the processor.

Next the image was visually inspected for 'asteroids'; these are small image defects which appear in the non-image areas of the 40 % screen (110 lpi). The better the pre-heat latitude, the higher the maximum 'asteroid'-free pre-heat temperature ($T_{max}$('asteroid'-free)). The results of the visual inspection for each pre-heat temperature are summarized in table 3.

**Table 3: occurence of asteroids versus pre-heat temperatures**

| | 99°C | 104°C | 116°C | 121°C | 127°C | 138°C | 143°C |
|---|---|---|---|---|---|---|---|
| Asteroids | No | No | No | Yes | Yes | Yes | Yes |

From the results listed in table 3 it can be seen, that the maximum 'asteroid'-free pre-heat temperature ($T_{max}$('asteroid'-free)) for the comparative example is 116°C.

**Examples 1 to 4**

The preparation of the printing plate precursor was identical to the comparative example 1, with the exception, that a radical stabilizer was added to the photolayer. The photolayer compositions are listed in table 4.

**Table 4: Composition of the photosensitive coating solution**

| Component | Example 1 Parts per weight (g) | Example 2 Parts per weight (g) | Example 3 Parts per weight (g) | Example 4 Parts per weight (g) |
|---|---|---|---|---|
| (A) | 181.31 | 180.92 | 181.31 | 181.62 |
| (B) | 36.14 | 36.14 | 36.14 | 36.14 |
| (C) | 381.23 | 381.23 | 381.23 | 381.23 |
| (D) | 10.97 | 10.97 | 10.97 | 10.97 |
| (E) | 207.11 | 207.11 | 207.11 | 207.11 |
| (F) | 16.58 | 16.58 | 16.58 | 16.58 |
| (G) | 0.77 | 0.77 | 0.77 | 0.77 |
| (H) | 25.50 | 25.50 | 25.50 | 25.50 |
| (I) | 650.34 | 651.60 | 650.34 | 650.07 |
| (J) | 1489.95 | 1489.95 | 1489.95 | 1489.95 |
| (ST-18) | 0.13 | 0.26 | - | - |
| (ST-21) | - | - | 0.13 | - |
| (ST-6) | - | - | - | 0.03 |

The pre-heat latitude of the printing plate precursor was evaluated as described in comparative example 1. Both the sensitivity and the $T_{max}$('asteroid'-free) were determined. The results are summarised in table 5.

**Table 5**

| | Comp. Example 1 | Example 1 | Example 2 | Example 3 | Example 4 |
|---|---|---|---|---|---|
| sensitivity ($\mu J/cm^2$) | 26 | 36 | 39 | 35 | 32 |
| $T_{max}$('aste roid'-free) | 116°C | 127°C | 127°C | 127°C | 127°C |

The examples 1 to 4 demonstrate, that the use of radical stabilizing compounds in the photolayer leads to an improved pre-heat latitude.

Examples 5 to 10 and comparative examples 2 to 4

Preparation and coating of the photosensitive layer

A composition was prepared (pw = parts per weight; wt.% = weight percentage) by mixing the ingredients as specified in table 6. This composition was coated on an electrochemically roughened and anodically oxidized aluminum sheet, the surface of which has been rendered hydrophilic by treatment with an aqueous solution of poly(vinylphosphonic acid) (oxide weight 3 g/$m^2$) and was dried at 105 °C. The resulting thickness of the layer was 1.5 g/$m^2$.

**Table 6: Composition of the photosensitive coating solution**

| Component | Parts per weight (g) |
|---|---|
| (A) | 552.37 |
| (B) | 109.79 |
| (C) | 1147.50 |
| (D) | 32.90 |
| (E) | 598.83 |
| (F) | 49.73 |
| (G) | 2.30 |
| (H) | 76.50 |
| (I) | 1937.38 |
| (J) | 452.25 |
| (ST-18) | 0.38 |

**Preparation and coating of the protective overcoat layer**

On top of the photosensitive layer a solution in water (containing 4.0 wt.%) of the composition as defined in table 7 was coated and then was dried at 120 °C.

**Table 7: coating composition of the protective overcoat**

| Component | Parts per weight (g) |
|---|---|
| (K) | 681.44 |
| (L) | 594.77 |
| (M) | 297.39 |
| (N) | 3.20 |
| (R) | 16.00 |
| (P) | 16.89 |
| (Q) | 38390.31 |

The protective overcoat for the examples and the comparative examples was coated at different dry coating weights as defined in table 8.

The pre-heat latitude of the printing plate precursors was evaluated as described in comparative example 1. Both the sensitivity and the $T_{max}$('asteroid'-free) were determined. Additionally the plate was inspected for defects i.e. non hardened defects in an image area. The results are summarised in table 8.

**Table 8**

| | Comp. Ex. 2 | Ex. 5 | Ex. 6 | Ex. 7 | Ex. 8 | Ex. 9 | Ex. 10 | Comp. Ex. 3 | Comp. Ex. 4 |
|---|---|---|---|---|---|---|---|---|---|
| dry coating weight of protective layer ($g/m^2$) | 0.25 | 0.50 | 0.75 | 1.00 | 1.25 | 1.50 | 1.75 | 2.00 | 2.25 |
| image defects | YES | NO | NO | NO | NO | NO | NO | NO | NO |
| sensitivity ($\mu J/cm^2$) | 52 | 39 | 39 | 39 | 39 | 39 | 39 | 39 | 39 |
| $T_{max}$ ('asteroid'-free) | 143°C | 143°C | 143°C | 143°C | 143°C | 143°C | 127°C | 121°C | 121°C |

The examples demonstrate that reducing the dry coating weight below 2.0 $g/m^2$ leads to a significant improvement in pre-heat latitude according to the present invention. At a low dry coating weight of 0.25 $g/m^2$ the image areas show defects (non hardened areas in image areas) and the sensitivity is slightly reduced (i.e. a higher value is obtained).

## Claims

1. A photopolymer printing plate precursor comprising in this order a photosensitive coating and a protective coating on a support, wherein said photosensitive coating comprises a composition that is photopolymerizable upon absorption of light, said composition comprising a binder, a polymerizable compound, a radical stabilizer, a sensitizer and a photoinitiator,
**characterized in that** said photoinitiator is a hexaarylbisimidazole compound and said protective layer has a dry coating weight from 0.5 to less than 2.0 $g/m^2$ and contains at least one type of poly(vinyl alcohol), having a saponification degree less than 93 mol%, and a poly(vinyl pyrrolidone) in an amount from 0 to 10 parts by weight of the poly(vinyl alcohol) .

2. A photopolymer printing plate precursor according to claim 1, wherein said protective layer, having a dry coating weight from 0.5 to less than 2.0 $g/m^2$, contains a mixture of at least two types of poly(vinyl alcohol), having an overall mean saponification degree of all the polyvinylalcohols of less than 93 mol-%, and a poly(vinyl pyrrolidone) in an amount from 0 to 10 parts by weight of the polyvinylalcohols.

3. A photopolymer printing plate precursor according to any of the preceding claims, wherein said radical stabilizer is a compound selected from the group consisting of phenoles, organic phosphites, organic phosphonites, amines, hydroxylamines, lactones, hydrochinones, divalent sulfur compounds and metal complexants, wherein phenoles comprise mono-, di- and trihydroxyphenyl compounds.

4. A photopolymer printing plate precursor according to any of the preceding claims, wherein said radical stabilizer is a compound selected from the group consisting of hindered phenoles, O-alkylated hydrochinones, organic phosphites, organic phosphonites, aromatic amines, hindered amines, dialkyl hydroxylamines, benzofuranones and dialkyl thiodipropionates.

5. A photopolymer printing plate precursor according to any of the preceding claims, wherein said binder is a copolymer containing monomeric units of an alpha,beta-unsaturated carboxylic acid and/or an alpha,beta-unsaturated dicarboxylic acid.

6. A photopolymer printing plate precursor according to any of the preceding claims, wherein said composition further comprises a polyfunctional (meth)acrylate or alkyl(meth)acrylate compound as a crosslinking agent.

7. A photopolymer printing plate precursor according to any of the preceding claims, wherein said polymerizable

compound contains an urethane and/or urea group and/or a tertiary amino group.

8. A photopolymer printing plate precursor according to any of the preceding claims, wherein said composition further comprising a radical chain transfer agent.

9. A photopolymer printing plate precursor according to claim 8, wherein said radical chain transfer agent is a sulfur containing compound.

10. A photopolymer printing plate precursor according to any of the preceding claims, wherein said sensitizer has a solubility in methyl ethyl ketone of at least 15 g/kg.

11. A photopolymer printing plate precursor according to any of the preceding claims, wherein said sensitizer is an optical brightening agent.

12. A photopolymer printing plate precursor according to claim 11, wherein said optical brightening agent has a structure according to one of the following formulae:

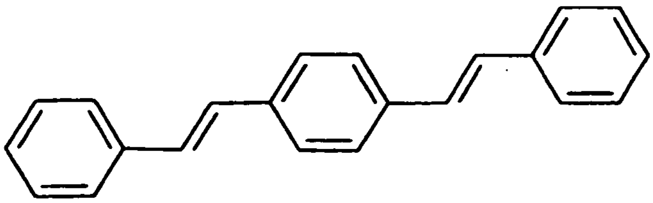

(III)

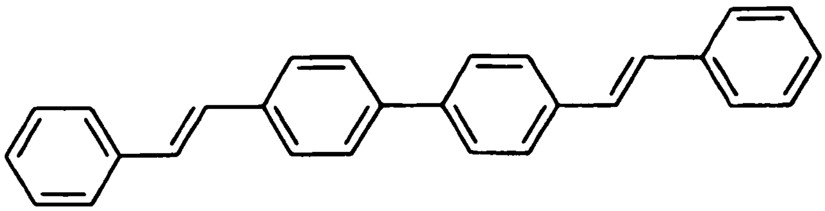

(IV)

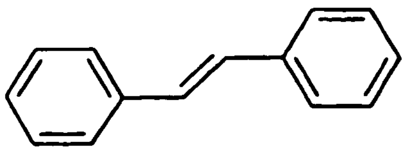

(V)

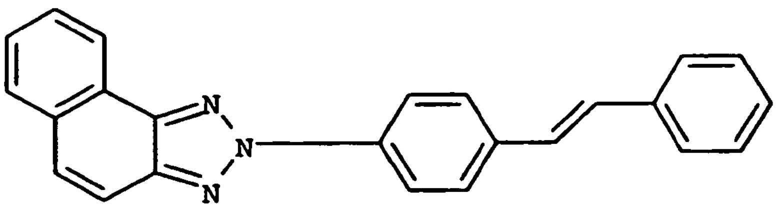

(VI)

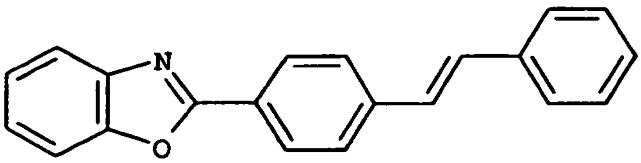

(VII)

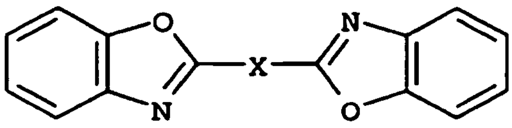

(VIII)

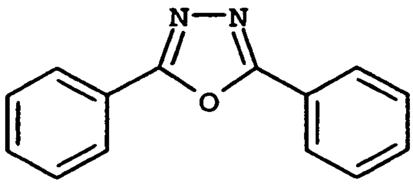

(IX)

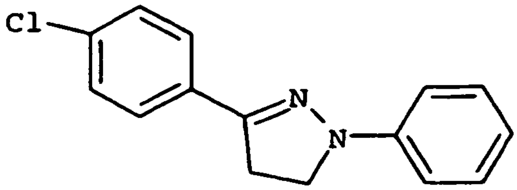

(X)

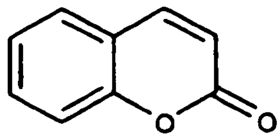

(XI)

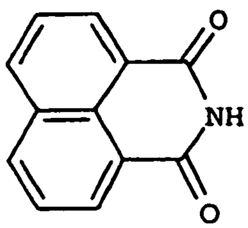

(XII)

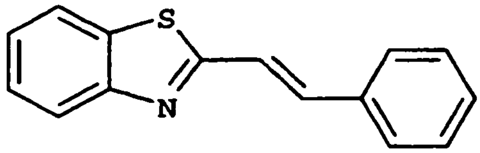

(XIII)

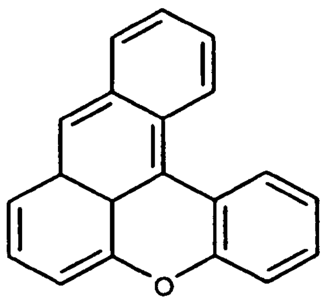

(XIV)

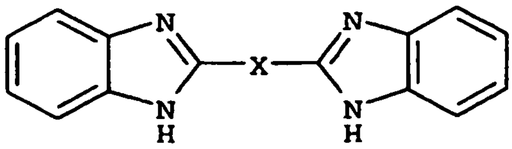

(XV)

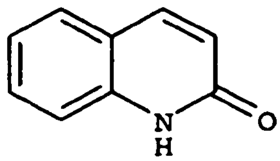

(XVI)

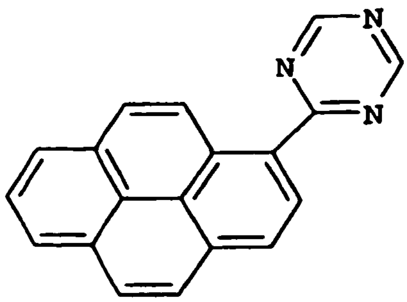

(XVII)

wherein X is one of the following groups, * denoting the position of attachment in the above formulae:

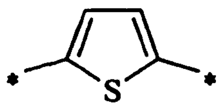

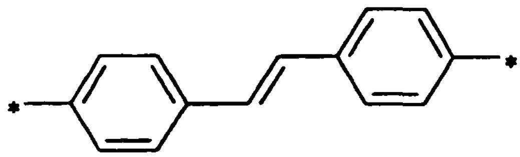

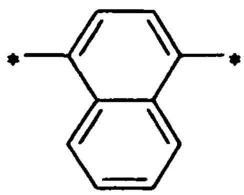

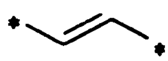

and wherein one or more of the nuclei in each of the above formulae (III) to (XVII) may be independently substituted by one or more groups selected from alkyl, alkoxy, alkylcarbonyl, alkoxycarbonyl, acyloxy, carboxyl, nitrile, amino, hydroxyl, alkylsulfonyl and aminosulfonyl.

**13.** A method of making a lithographic printing plate comprising the steps of

- providing a photopolymer printing plate precursor as defined in any of the preceding claims,

- exposing said printing plate precursor with a laser having an emission wavelength in the range from 300 to 450 nm,
- heating the plate to a temperature, when measured at the back of the plate, from about 90°C to 150°C,
- washing off the protective coating, and
- processing the printing plate precursor in an aqueous alkaline developer.

**14.** A method according to claim 13, wherein said printing plate precursor is exposed with a laser having an emission wavelength in the range from 380 to 430 nm.

**15.** A method according to any of the claims 13 or 14, wherein said printing plate precursor is exposed at an energy density, measured on the surface of the plate, of 100 μJ/$cm^2$ or less.

**Patentansprüche**

**1.** Eine Fotopolymerdruckplattenvorstufe, die der Reihe nach eine strahlungsempfindliche Beschichtung und eine Schutzbeschichtung auf einem Träger umfasst, wobei die strahlungsempfindliche Beschichtung eine bei Absorption von Licht fotopolymerisierbare Zusammensetzung enthält, wobei die Zusammensetzung ein Bindemittel, eine polymerisierbare Verbindung, einen Radikalstabilisator, ein Sensibilisierungsmittel und einen Fotoinitiator enthält, **dadurch gekennzeichnet, dass** der Fotoinitiator eine Hexaarylbisimidazol-Verbindung ist und die Schutzschicht ein Trockenschichtgewicht zwischen 0,5 und weniger als 2,0 g/$m^2$ aufweist und mindestens einen Poly(vinylalkohol)-Typ mit einem Verseifungsgrad von weniger als 93 Mol-% und ein Poly(vinylpyrrolidon) in einer Menge zwischen 0 und 10 Gewichtsteilen, bezogen auf das Gewicht des Poly(vinylalkohols), enthält.

**2.** Fotopolymerdruckplattenvorstufe nach Anspruch 1, **dadurch gekennzeichnet, dass** die Schutzschicht mit einem Trockenschichtgewicht zwischen 0,5 und weniger als 2,0 g/$m^2$ ein Gemisch aus mindestens zwei Poly(vinylalkohol)-Typen, wobei der mittlere Gesamtverseifungsgrad aller Polyvinylalkohole bei weniger als 93 Mol-% liegt, und einem Poly(vinylpyrrolidon) in einer Menge zwischen 0 und 10 Gewichtsteilen, bezogen auf das Gewicht der Polyvinylalkohole, enthält.

**3.** Fotopolymerdruckplattenvorstufe nach einem der vorstehenden Ansprüche, **dadurch gekennzeichnet, dass** der Radikalstabilisator eine Verbindung aus der Gruppe bestehend aus Phenolen, organischen Phosphiten, organischen Phosphoniten, Aminen, Hydroxylaminen, Lactonen, Hydrochinonen, divalenten Schwefelverbindungen und Metallkomplexbildnern ist, wobei Phenole Mono-, Di- und Trihydroxyphenylverbindungen umfassen.

**4.** Fotopolymerdruckplattenvorstufe nach einem der vorstehenden Ansprüche, **dadurch gekennzeichnet, dass** der Radikalstabilisator eine Verbindung aus der Gruppe bestehend aus gehinderten Phenolen, O-alkylierten Hydrochinonen, organischen Phosphiten, organischen Phosphoniten, aromatischen Aminen, gehinderten Aminen, Dialkylhydroxylaminen, Benzofuranonen und Dialkylthiodipropionaten ist.

**5.** Fotopolymerdruckplattenvorstufe nach einem der vorstehenden Ansprüche, **dadurch gekennzeichnet, dass** das Bindemittel ein Copolymer, das Monomereinheiten einer α,β-ungesättigten Carbonsäure und/oder einer α,β-ungesättigten Dicarbonsäure enthält, ist.

**6.** Fotopolymerdruckplattenvorstufe nach einem der vorstehenden Ansprüche, **dadurch gekennzeichnet, dass** die Zusammensetzung ferner eine polyfunktionelle (Meth)acrylat- oder Alkyl(meth)acrylatverbindung als Vernetzungsmittel enthält.

**7.** Fotopolymerdruckplattenvorstufe nach einem der vorstehenden Ansprüche, **dadurch gekennzeichnet, dass** die polymerisierbare Verbindung eine Urethangruppe und/oder Harnstoffgruppe und/oder eine tertiäre Aminogruppe enthält.

**8.** Fotopolymerdruckplattenvorstufe nach einem der vorstehenden Ansprüche, **dadurch gekennzeichnet, dass** die Zusammensetzung ferner ein Radikalkettenübertragungsmittel enthält.

**9.** Fotopolymerdruckplattenvorstufe nach Anspruch 8, **dadurch gekennzeichnet, dass** das Radikalkettenübertragungsmittel eine schwefelhaltige Verbindung ist.

**10.** Fotopolymerdruckplattenvorstufe nach einem der vorstehenden Ansprüche, **dadurch gekennzeichnet, dass** die Löslichkeit in Methylethylketon des Sensibilisierungsmittels bei mindestens 15 g/kg liegt.

**11.** Fotopolymerdruckplattenvorstufe nach einem der vorstehenden Ansprüche, **dadurch gekennzeichnet, dass** das Sensibilisierungsmittel ein optisches Aufhellmittel ist.

**12.** Fotopolymerdruckplattenvorstufe nach Anspruch 11, **dadurch gekennzeichnet, dass** das optische Aufhellmittel eine Struktur gemäß einer der folgenden Formeln aufweist :

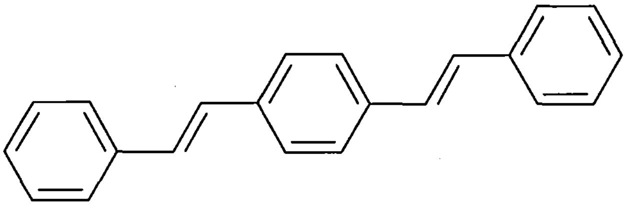
(III)

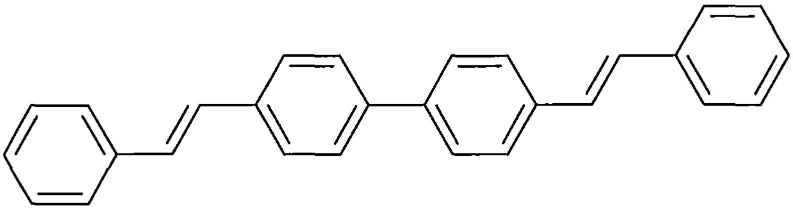
(IV)

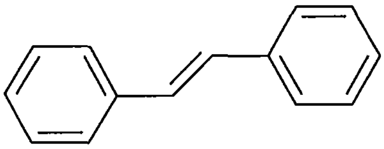
(V)

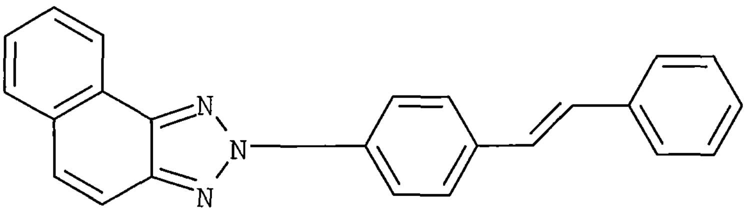
(VI)

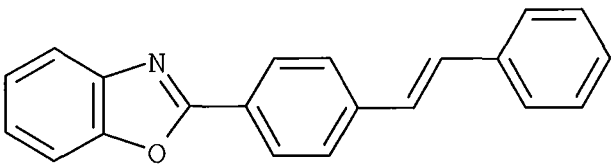
(VII)

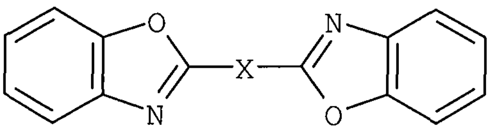
(VIII)

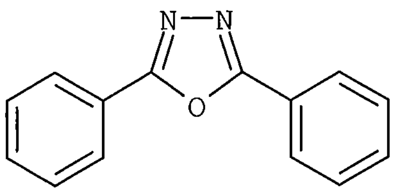

(IX)

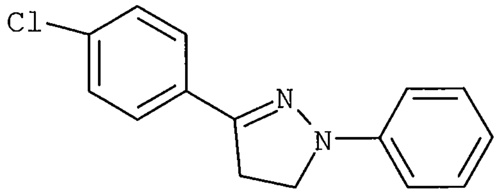

(X)

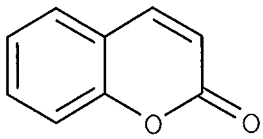

(XI)

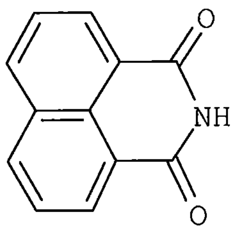

(XII)

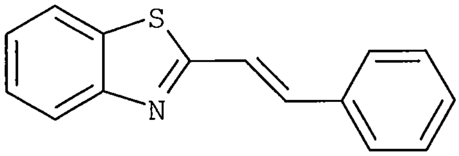

(XIII)

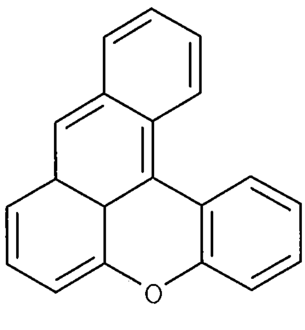

(XIV)

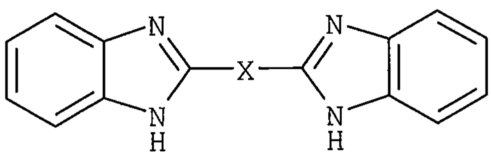

(XV)

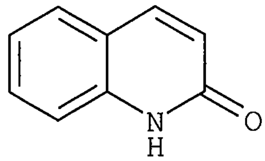

(XVI)

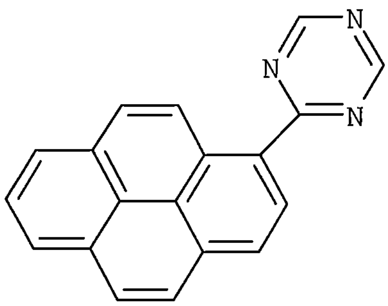

(XVII)

in denen X eine der folgenden Gruppen bedeutet, wobei * die Bindungsstelle in den obigen Formeln bezeichnet :

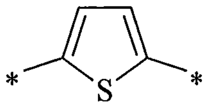

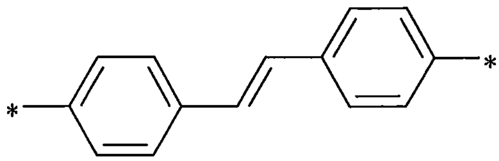

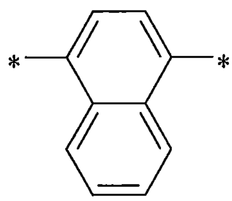

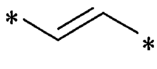

und in denen einer oder mehrere der Ringe in jeder der obigen Formeln (III) bis (XVII) unabhängig voneinander durch eine oder mehrere Gruppen aus der Gruppe bestehend aus Alkyl, Alkoxy, Alkylcarbonyl, Alkoxycarbonyl, Acyloxy, Carboxyl, Nitril, Amino, Hydroxyl, Alkylsulfonyl und Aminosulfonyl substituiert sein kann.

**13.** Ein Verfahren zur Herstellung einer lithografischen Druckplatte, umfassend die folgenden Schritte :

- Bereitstellen einer wie nach einem der vorstehenden Ansprüche definierten Fotopolymerdruckplattenvorstufe,
- Belichtung der Druckplattenvorstufe mit einem Laser mit einer Emissionswellenlänge zwischen 300 und 450 nm,
- Erwärmung der Platte auf eine an der Rückseite der Platte gemessene Temperatur zwischen etwa 90°C und 150°C,
- Auswaschen der Schutzbeschichtung, und

- Entwicklung der Druckplattenvorstufe in einem wässrigalkalischen Entwickler.

**14.** Verfahren nach Anspruch 13, **dadurch gekennzeichnet, dass** die Druckplattenvorstufe mit einem Laser mit einer Emissionswellenlänge zwischen 380 und 430 nm belichtet wird.

**15.** Verfahren nach einem der Ansprüche 13 oder 14, **dadurch gekennzeichnet, dass** die Druckplattenvorstufe bei einer auf der Plattenoberfläche gemessenen Energiedichte von höchstens 100 $\mu J/cm^2$ belichtet wird.

## Revendications

**1.** Un précurseur d'une plaque d'impression photopolymère, comprenant, dans l'ordre indiqué, un revêtement photosensible et un revêtement protecteur sur un support, ledit revêtement photosensible contenant une composition photopolymérisable par absorption de lumière, ladite composition contenant un liant, un composé polymérisable, un stabilisateur de radicaux, un sensibilisateur et un photo-initiateur,
**caractérisé en ce que** le photo-initiateur contient un composé d'hexaarylbisimidazole et que la couche protectrice présente une épaisseur de couche sèche comprise entre 0,5 et moins de 2,0 $g/m^2$ et contient au moins un type d'alcool polyvinylique ayant un degré de saponification inférieur à 93 moles % et une polyvinylpyrolidone utilisée dans une quantité comprise entre 0 et 10 parties en poids par rapport au poids de l'alcool polyvinylique.

**2.** Précurseur d'une plaque d'impression photopolymère selon la revendication 1, **caractérisé en ce que** la couche protectrice ayant une épaisseur de couche sèche comprise entre 0,5 et moins de 2,0 $g/m^2$ contient un mélange d'au moins deux types d'alcool polyvinylique, le degré de saponification moyen total de tous les alcools polyvinyliques étant inférieur à 93 moles %, et d'une poly(vinylpyrolidone) utilisée dans une quantité comprise entre 0 et 10 parties en poids par rapport au poids des alcools polyvinyliques.

**3.** Précurseur d'une plaque d'impression photopolymère selon l'une quelconque des revendications précédentes, **caractérisé en ce que** le stabilisateur de radicaux est un composé choisi parmi le groupe composé de phénols, de phosphites organiques, de phosphonites organiques, d'amines, d'hydroxylamines, de lactones, d'hydroquinones, de composés sulfurés divalents et d'agents formateurs de complexes métalliques, lesdits phénols comprenant des composés mono-, di- et trihydroxyphényliques.

**4.** Précurseur d'une plaque d'impression photopolymère selon l'une quelconque des revendications précédentes, **caractérisé en ce que** le stabilisateur de radicaux est un composé choisi parmi le groupe composé de phénols encombrés, d'hydroquinones O-alkylées, de phosphites organiques, de phosphonites organiques, d'amines aromatiques, d'amines encombrées, de dialkylhydroxylamines, de benzofuranones et de dialkylthiodipropionates.

**5.** Précurseur d'une plaque d'impression photopolymère selon l'une quelconque des revendications précédentes, **caractérisé en ce que** le liant est un copolymère comprenant des unités monomères d'un acide carboxylique $\alpha$,$\beta$-insaturé et/ou d'un acide dicarboxylique $\alpha$,$\beta$-insaturé.

**6.** Précurseur d'une plaque d'impression photopolymère selon l'une quelconque des revendications précédentes, **caractérisé en ce que** la composition contient en outre un composé de (méth)acrylate polyfonctionnel ou un composé d'alkyl(méth)acrylate polyfonctionnel comme agent de réticulation.

**7.** Précurseur d'une plaque d'impression photopolymère selon l'une quelconque des revendications précédentes, **caractérisé en ce que** le composé polymérisable contient un groupe uréthane et/ou un groupe urée et/ou un groupe amino tertiaire.

**8.** Précurseur d'une plaque d'impression photopolymère selon l'une quelconque des revendications précédentes, **caractérisé en ce que** la composition contient en outre un agent de transfert de chaîne radicalaire.

**9.** Précurseur d'une plaque d'impression photopolymère selon la revendication 8, **caractérisé en ce que** l'agent de transfert de chaîne radicalaire est un composé sulfuré.

**10.** Précurseur d'une plaque d'impression photopolymère selon l'une quelconque des revendications précédentes, **caractérisé en ce que** le sensibilisateur présente une solubilité minimale dans de la méthyléthylcétone de 15 g/kg.

**11.** Précurseur d'une plaque d'impression photopolymère selon l'une quelconque des revendications précédentes, **caractérisé en ce que** le sensibilisateur est un agent de blanchiment optique.

**12.** Précurseur d'une plaque d'impression photopolymère selon la revendication 11, **caractérisé en ce que** l'agent de blanchiment optique présente une structure répondant à l'une des formules reprises ci-après :

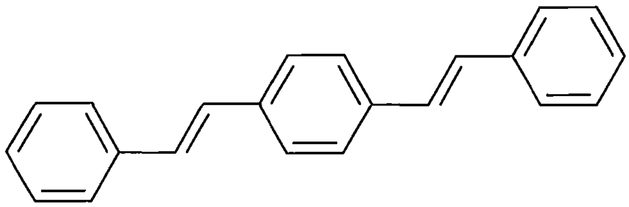

(III)

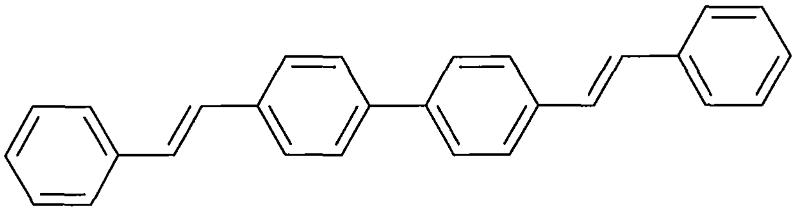

(IV)

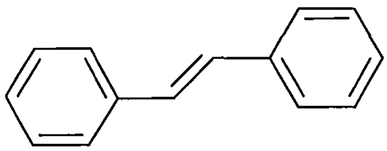

(V)

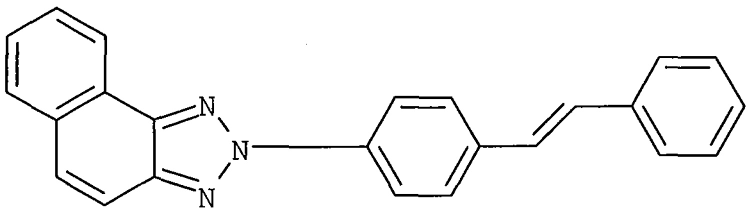

(VI)

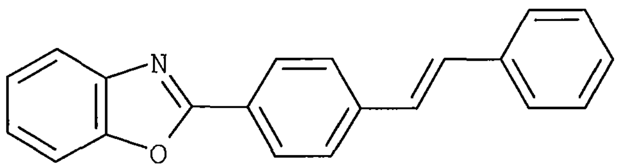

(VII)

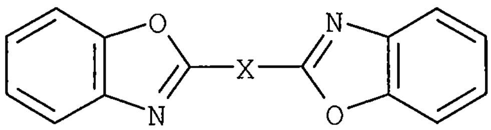

(VIII)

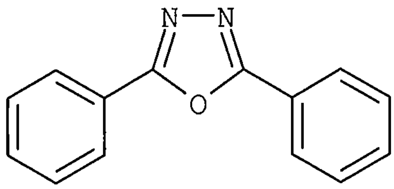

(IX)

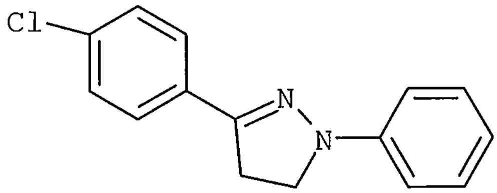

(X)

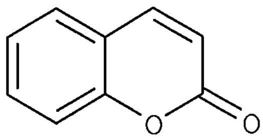

(XI)

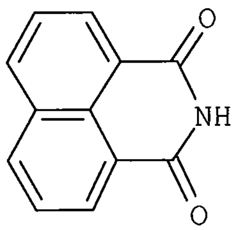

(XII)

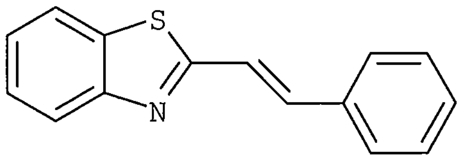

(XIII)

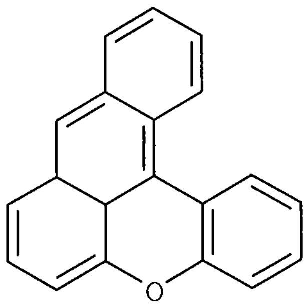

(XIV)

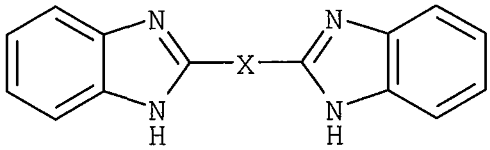

(XV)

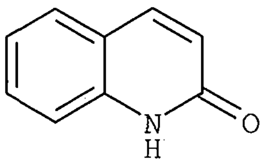

(XVI)

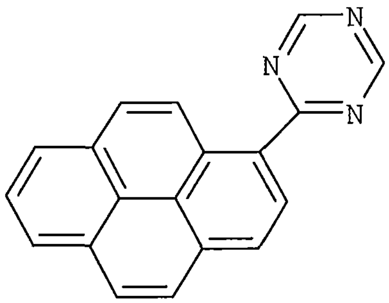

(XVII)

où X représente un des groupes ci-après, où * représente la position de liaison dans les formules reprises ci-dessus :

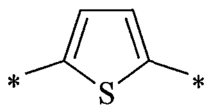

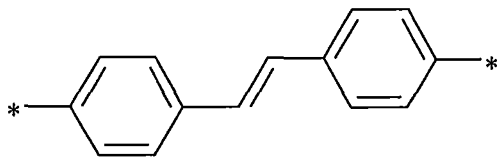

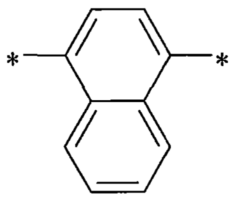

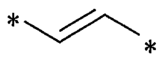

et où un ou plusieurs des noyaux dans chacune des formules (III) à (XVII) reprises ci-dessus peuvent être substitués, indépendamment l'un de l'autre, par un ou plusieurs groupes choisis parmi le groupe composé d'un groupe alkyle, d'un groupe alkoxy, d'un groupe alkylcarbonyle, d'un groupe alkoxycarbonyle, d'un groupe acyloxy, d'un groupe carboxyle, d'un groupe nitrile, d'un groupe amino, d'un groupe hydroxyle, d'un groupe alkylsulfonyle et d'un groupe aminosulfonyle.

**13.** Un procédé pour la confection d'une plaque d'impression lithographique, comprenant les étapes ci-après :

- la mise à disposition d'un précurseur d'une plaque d'impression photopolymère tel que défini selon l'une quelconque des revendications précédentes,
- l'exposition du précurseur d'une plaque d'impression à l'aide d'un laser dont la longueur d'onde d'émission se situe entre 300 et 450 nm,
- le chauffage de la plaque à une température, mesurée sur la couche dorsale de la plaque, qui est comprise entre environ 90°C et 150°C,

- l'élimination par lavage du revêtement protecteur, et
- le développement du précurseur de plaque d'impression dans un révélateur alcalin aqueux.

**14.** Procédé selon la revendication 13, **caractérisé en ce que** le précurseur de plaque d'impression est exposé à l'aide d'un laser dont la longueur d'onde d'émission se situe entre 380 et 430 nm.

**15.** Procédé selon l'une quelconque des revendications 13 ou 14, **caractérisé en ce que** l'exposition du précurseur de plaque d'impression est effectuée à une densité d'énergie maximale, mesurée sur la surface de la plaque, de 100 $\mu J/cm^2$.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- DE 2629883 A1
- DE 2629883
- EP 1148387 A1
- EP 1280006 A2
- EP 0924570 A1
- EP 1035435 A2
- EP 1070990 A1
- EP 1081552 A1
- EP 0738929 A
- EP 1288722 A
- EP 1048982 A1
- EP 985683 A1
- EP 1091247 A2
- DE 1470154
- EP 24629 A
- EP 107792 A
- US 4410621 A
- EP 215453 A
- DE 3211312
- EP 1091247 A
- EP 287818 A
- EP 316706 A
- EP 355387 A
- DE 2822190
- DE 2064079
- DE 19915717
- DE 19933139
- EP 352630 B1
- EP 1072956 A


### Non-patent literature cited in the description


- Electronic Release. Ullmann's Encyclopedia of Industrial Chemistry. Wiley-VCH, 1998
- **B.P. LUGOVKIN ; B.A. ARBUZOV.** *Doklady Akademii Nauk SSSR,* 1948, vol. 59, 1301-1304